(19) Europäisches Patentamt
European Patent Office
Office européen des brevets

(11) EP 3 627 577 A1

(12) **EUROPEAN PATENT APPLICATION**
published in accordance with Art. 153(4) EPC

(43) Date of publication:
**25.03.2020 Bulletin 2020/13**

(21) Application number: **18801636.4**

(22) Date of filing: **05.04.2018**

(51) Int Cl.:
***H01L 51/44*** *(2006.01)* ***H01G 9/20*** *(2006.01)*

(86) International application number:
**PCT/JP2018/014503**

(87) International publication number:
**WO 2018/211848 (22.11.2018 Gazette 2018/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.05.2017 JP 2017100282**

(71) Applicant: **FUJIFILM Corporation**
**Tokyo 106-8620 (JP)**

(72) Inventors:
- **SATO Hirotaka**
  **Ashigarakami-gun**
  **Kanagawa 258-8577 (JP)**
- **SHIROKANE Kenji**
  **Ashigarakami-gun**
  **Kanagawa 258-8577 (JP)**
- **NOMURA Kimiatsu**
  **Ashigarakami-gun**
  **Kanagawa 258-8577 (JP)**

(74) Representative: **Hoffmann Eitle**
**Patent- und Rechtsanwälte PartmbB**
**Arabellastraße 30**
**81925 München (DE)**

# (54) PHOTOELECTRIC CONVERSION ELEMENT, SOLAR CELL, METHOD FOR PRODUCING PHOTOELECTRIC CONVERSION ELEMENT, AND COMPOSITION FOR FORMING PHOTOSENSITIVE LAYER

(57) Provided are a photoelectric conversion element which contains a perovskite compound in a photosensitive layer but still exhibits high temperature change resistance, a solar cell, a method for manufacturing a photoelectric conversion element, and a photosensitive-layer-forming composition. The photoelectric conversion element includes a first electrode that has a photosensitive layer containing a light absorbing agent on a conductive support; and a second electrode that is opposite to the first electrode, in which the light absorbing agent contains a perovskite compound, and a compound represented by Formula (A-0).

Formula (A-0) (G)p-L

In the formula, G represents a group or a salt such as $-P(=O)(OR^a)_2$ and $-P(=O)(O^-Ya^+)_2$; $R^a$ represents a hydrogen atom or a substituent; Ya represents a counter salt; p is an integer of 1 or more; and L represents an aliphatic hydrocarbon group not having an amino group.

EP 3 627 577 A1

FIG. 1

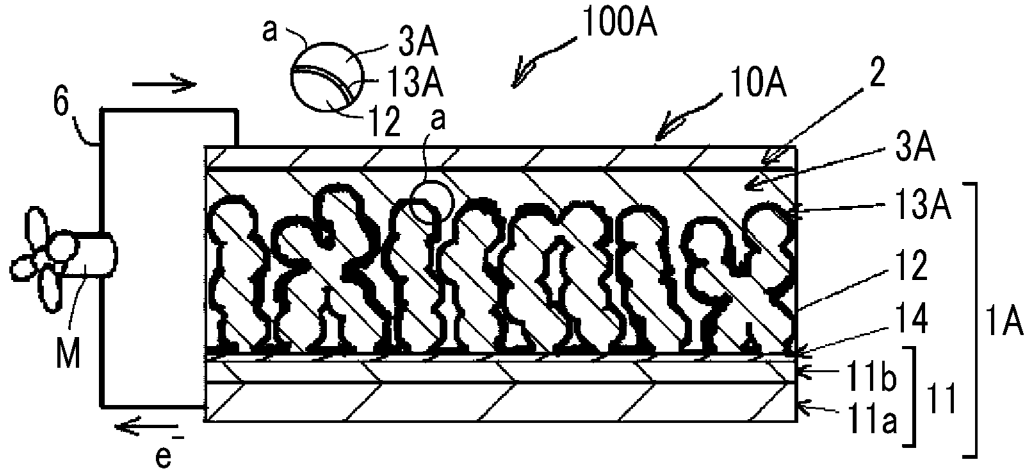

## Description

### BACKGROUND OF THE INVENTION

1. Field of the invention

The present invention relates to a photoelectric conversion element, a solar cell, a method for manufacturing a photoelectric conversion element, and a photosensitive-layer-forming composition.

2. Description of the Related Art

Photoelectric conversion elements are used in a variety of optical sensors, copiers, solar cells, and the like. Practical use of solar cells as cells using non-exhaustible solar energy is proceeding. Among these, research and development of dye sensitized solar cells, in which an organic dye, a Ru bipyridyl complex, or the like is used as a sensitizer, are actively in progress, and the photoelectric conversion efficiency thereof reaches approximately 11%.

Meanwhile, in recent years, solar cells using a metal halide as a compound having a perovskite-type crystal structure are attracting attention.

For example, WO2016/143525A discloses a photoelectric conversion element including a photosensitive layer that contains, as a light absorbing agent, a compound having a perovskite-type crystal structure in which at least a part of an anion is substituted by a $C(=O)O^{-}$anion or a $C(=S)S^{-}$anion. It is disclosed that this photoelectric conversion element is excellent in moisture resistance and manufacturing stability (uniformity of durability (moisture resistance) between elements). JP2017-028093A discloses a thin film solar cell including a photoelectric conversion layer composed of a layer containing $CH_3NH_3PbI_3$, an organic semiconductor film containing poly-TPD (Poly[N,N'-bis(4-butylphenyl)-N,N'-bis(phenyl)-benzidine]), and a site containing fluorinated octylphosphonic acid which is provided between the layer containing $CH_3NH_3PbI_3$ and the organic semiconductor film.

In addition, Nature Communications 6, 10030 (2015) discloses a solar cell including a photosensitive layer produced using a perovskite precursor solution to which hypophosphorous acid is added. Nature Chemistry 7, 2015, 703-711 discloses a solar cell including a photosensitive layer produced using a perovskite precursor solution containing butyl phosphate 4-ammonium chloride as a crosslinking agent having a perovskite-type crystal structure.

### SUMMARY OF THE INVENTION

Photoelectric conversion elements or solar cells are generally installed outdoors. Accordingly, a photoelectric conversion performance against temperature changes in surrounding environments is required to be maintained. However, in a case where temperature changes in environments are repeated, in a photoelectric conversion element or solar cell in which a compound having a perovskite-type crystal structure (hereinafter, will also be referred to as a "perovskite compound") is used in a photosensitive layer, characteristics (also referred to as temperature change resistance) of suppressing a decrease in the photoelectric conversion performance are not sufficient, and there is still room for improvement.

An object of the present invention is to provide a photoelectric conversion element which contains a perovskite compound in a photosensitive layer but still exhibits high temperature change resistance, and a solar cell using this photoelectric conversion element.

Another object of the present invention is to provide a method for manufacturing the above-mentioned photoelectric conversion element, and a photosensitive-layer-forming composition that can be preferably used for the manufacture of the photoelectric conversion element.

In a photoelectric conversion element having a photosensitive layer containing a perovskite compound as a light absorbing agent, the inventors of the present invention have incorporated a compound represented by Formula (A-0) to be described later in the light absorbing agent, in addition to the perovskite compound (have allowed the compound represented by Formula (A-0) to coexist), and therefore have found that a decrease in a photoelectric conversion performance can be effectively suppressed against repeated temperature changes. The present invention has been completed through further investigation based on these findings.

That is, the above-described objects of the present invention have been achieved by the following means.

<1> A photoelectric conversion element, comprising: a first electrode that includes a photosensitive layer containing a light absorbing agent on a conductive support; and a second electrode that is opposite to the first electrode,
in which the light absorbing agent contains a compound having a perovskite-type crystal structure that has a cation of an element of Group 1 in the periodic table or an organic cation, a cation of a metal atom other than elements of Group 1 in the periodic table, and an anion of an anionic atom or atomic group, and contains a compound represented

by Formula (A-0).

Formula (A-0) (G)p-L

In the formula, G represents a group or a salt selected from the group consisting of $-SO_3R^a$, $-SO_3^-Ya^+$, $-P(=O)(OR^a)_2$, $-P(=O)(O^-Ya^+)_2$, $-P(=O)R^G(OR^a)$, $-P(=O)R^G(O^-Ya^+)$, $-B(OR^a)_2$, $-OB(OR^a)_2$, and $-B(OR^a)_3^-Ya^+$; $R^a$ represents a hydrogen atom or a substituent; $R^G$ represents a substituent; Ya represents a counter salt; p is an integer of 1 or more; and L represents an aliphatic hydrocarbon group, an aromatic hydrocarbon group, an aromatic heterocyclic group, or an aliphatic heterocyclic group, provided that L does not have an amino group.

<2> The photoelectric conversion element according to <1>, in which, in the photosensitive layer, a molar ratio between a content $[M^{PCA}]$ of the compound represented by Formula (A-0) and a content $[M^{PMC}]$ of the cation of the metal atom is within the following range.

$[M^{PCA}]:[M^{PMC}]$ = 4:1 to 1:10000

<3> The photoelectric conversion element according to <2>, in which the molar ratio is within the following range.

$[M^{PCA}]$: $[M^{PMC}]$ = 1:10 to 1:1000

<4> The photoelectric conversion element according to <2> or <3>, in which the molar ratio is within the following range.

$[M^{PCA}]:[M^{PMC}]$ = 1:50 to 1:800

<5> The photoelectric conversion element according to any one of <1> to <4>, in which G is $-P(=O)(OR^a)_2$ or $-P(=O)(O^-Ya^+)_2$.

<6> The photoelectric conversion element according to any one of <1> to <5>, in which L is an aliphatic hydrocarbon group or an aromatic hydrocarbon group.

<7> The photoelectric conversion element according to any one of <1> to <6>, in which L has a substituent selected from the following group $L^{SG}$.

<Group $L^{SG}$>

An alkyl group, an alkenyl group, an alkynyl group, an aryl group, an alkoxy group, an aryloxy group, a heteroaryloxy group, an alkylthio group, an arylthio group, a heteroarylthio group, an alkoxycarbonyl group, an aryloxycarbonyl group, a heteroaryloxycarbonyl group, an alkylthiocarbonyl group, an arylthiocarbonyl group, a heteroarylthiocarbonyl group, an alkylcarbonyloxy group, an arylcarbonyloxy group, a heteroarylcarbonyloxy group, an alkylcarbonylthio group, an arylcarbonylthio group, a heteroarylcarbonylthio group, a hydroxy group, a mercapto group, an acyl group, a halogen atom, a cyano group, a silyl group, a heteroaryl group, an aliphatic heterocyclic group, and a carbamoyl group

<8> A solar cell which is formed of the photoelectric conversion element according to any one of <1> to <7>.

<9> A method for manufacturing a photoelectric conversion element which includes a first electrode having a photosensitive layer on a conductive support, and a second electrode that is opposite to the first electrode, the method comprising:

a step of applying, on the conductive support, a photosensitive-layer-forming composition which contains a perovskite precursor compound for forming a compound having a perovskite-type crystal structure that has a cation of an element of Group 1 in the periodic table or an organic cation, a cation of a metal atom other than elements of Group 1 in the periodic table, and an anion of an anionic atom or atomic group, and which contains a compound represented by Formula (A-0).

Formula (A-0) (G)p-L

In the formula, G represents a group or a salt selected from the group consisting of $-SO_3R^a$, $-SO_3^-Ya^+$, $-P(=O)(OR^a)_2$, $-P(=O)(O^-Ya^+)_2$, $-P(=O)R^G(OR^a)$, $-P(=O)R^G(O^-Ya^+)$, $-B(OR^a)_2$, $-OB(OR^a)_2$, and $-B(OR^a)_3^-Ya^+$; $R^a$ represents a hydrogen atom or a substituent; $R^G$ represents a substituent; Ya represents a counter salt; p is an integer of 1 or more; and L represents an aliphatic hydrocarbon group, an aromatic hydrocarbon group, an aromatic heterocyclic group, or an aliphatic heterocyclic group, provided that L does not have an amino group.

<10> The method for manufacturing a photoelectric conversion element according to <9>, in which the perovskite precursor compound includes a compound represented by Formula (A-2) and a compound represented by Formula (A-3).

Formula (A-2) $MX_2$

Formula (A-3) AX

In Formula (A-2), M represents a metal atom other than elements of Group 1 in the periodic table, and X represents

an anionic atom or an atomic group. In Formula (A-3), A represents an element of Group 1 in the periodic table or a cationic organic group, and X represents an anionic atom or an atomic group.

<11> A photosensitive-layer-forming composition comprising: a compound represented by Formula (A-0); a compound represented by Formula (A-2); and a compound represented by Formula (A-3).

Formula (A-0) (G)p-L

Formula (A-2) $MX_2$

Formula (A-3) AX

In Formula (A-0), G represents a group or a salt selected from the group consisting of $-SO_3R^a$, $-SO_3^-Ya^+$, $-P(=O)(OR^a)_2$, $-P(=O)(O^-Ya^+)_2$, $-P(=O)R^G(OR^a)$, $-P(=O)R^G(O^-Ya^+)$, $-B(OR^a)_2$, $-OB(OR^a)_2$, and $-B(OR^a)_3^-Ya^+$; $R^a$ represents a hydrogen atom or a substituent; $R^G$ represents a substituent; Ya represents a counter salt; p is an integer of 1 or more; and L represents an aliphatic hydrocarbon group, an aromatic hydrocarbon group, an aromatic heterocyclic group, or an aliphatic heterocyclic group, provided that L does not have an amino group.
In Formula (A-2), M represents a metal atom other than elements of Group 1 in the periodic table, and X represents an anionic atom or an atomic group.
In Formula (A-3), A represents an element of Group 1 in the periodic table or a cationic organic group, and X represents an anionic atom or an atomic group.

<12> The photosensitive-layer-forming composition according to <11>, in which a molar ratio between a content $[M^{CCA}]$ of the compound represented by Formula (A-0) and a content $[M^{CMC}]$ of the compound $MX_2$ represented by Formula (A-2) is within the following range.
$[M^{CCA}]:[M^{CMC}]$ = 1:10 to 1:1000
<13> The photosensitive-layer-forming composition according to <11> or <12>, further comprising an organic solvent.

In the present specification, parts of respective formulae may be expressed as a rational formula for understanding of chemical structures of compounds. According to this, in the respective formulae, partial structures are called (substituent) groups, ions, atoms, and the like, but in the present specification, the partial structures may represent element groups or elements which constitute (substituent) groups or ions represented by the formulae in addition to the (substituent) groups, the ions, the atoms, and the like.
In the present specification, with regard to expression of compounds (including a complex and a dye), the expression is also used to indicate salts of the compounds and ions of the compounds in addition to the compounds. In addition, with regard to compounds for which substitution or non-substitution is not specified, the compounds also include compounds which have any substituent in a range not imparting a desired effect. This is also true of substituents, linking groups, and the like (hereinafter, referred to as "substituents and the like").
In the present specification, in a case where a plurality of substituents expressed using specific symbols or a plurality of substituents and the like are simultaneously defined, the respective substituents and the like may be identical to or different from each other unless otherwise stated. This is also true of definition of the number of substituents and the like. In addition, in a case of approaching each other (particularly, in a case of being close to each other), the plurality of substituents and the like may be linked to each other to form a ring unless otherwise stated. In addition, rings, for example, aliphatic rings, aromatic rings, and hetero rings may be additionally condensed together to form a condensed ring.
In the present specification, numerical ranges represented by using "to" include ranges including numerical values before and after "to" as the lower limit and the upper limit.
Even in a case where the photoelectric conversion element and the solar cell of the present invention are installed outdoors or the like where temperature changes in surrounding environments are repeated, a decrease in a photoelectric conversion performance is suppressed, and thereby the photoelectric conversion element and the solar cell of the present invention exhibit high temperature change resistance. In addition, the photoelectric conversion element and the solar cell of the present invention which have the above-mentioned excellent characteristic can be suitably manufactured by the method for manufacturing a photoelectric conversion element and the photosensitive-layer-forming composition of the present invention.

## BRIEF DESCRIPTION OF THE DRAWINGS

Fig. 1 is a cross-sectional view (including an enlarged view of a circle part in the layer) schematically illustrating a preferred aspect of a photoelectric conversion element of the present invention.

Fig. 2 is a cross-sectional view schematically illustrating another preferred aspect of the photoelectric conversion element having a thick photosensitive layer of the present invention.

Fig. 3 is a cross-sectional view schematically illustrating still another preferred aspect of the photoelectric conversion element of the present invention.

Fig. 4 is a cross-sectional view schematically illustrating still another preferred aspect of the photoelectric conversion element of the present invention.

Fig. 5 is a cross-sectional view schematically illustrating still another preferred aspect of the photoelectric conversion element of the present invention.

Fig. 6 is a cross-sectional view schematically illustrating still another preferred aspect of the photoelectric conversion element of the present invention.

## DESCRIPTION OF THE PREFERRED EMBODIMENTS

[Photoelectric conversion element]

A photoelectric conversion element according to the embodiment of the present invention includes a first electrode that has a form in which a photosensitive layer is provided on a conductive support, and a second electrode that is opposite to the first electrode. A case where the first electrode and the second electrode are opposed to each other means both aspect in which the first electrode and the second electrode are laminated in a state of being in contact with each other, and aspect in which the first electrode and the second electrode are laminated via another layer (that is, an aspect in which the first electrode and the second electrode are provided so as to be opposed to each other with another layer sandwiched therebetween). In addition, in the first electrode, the photosensitive layer is disposed on a side closer to the second electrode than the conductive support.

In the present invention, the case in which the photosensitive layer is provided on the conductive support means an aspect in which the photosensitive layer is provided to be in contact with (directly provided on) a surface of the conductive support, and an aspect in which the photosensitive layer is provided on an upper side of the surface of the conductive support through another layer.

In the aspect in which the photosensitive layer is provided on the upper side of the surface of the conductive support through another layer, as the other layer that is provided between the conductive support and the photosensitive layer, there is no particular limitation as long as the other layer does not deteriorate a cell performance of a solar cell. Examples thereof include a porous layer, a blocking layer, an electron transport layer, a hole transport layer, and the like.

In the present invention, examples of the aspect in which the photosensitive layer is provided on the upper side of the surface of the conductive support through another layer includes an aspect in which the photosensitive layer is provided on the surface of the porous layer in a thin film shape (refer to Fig. 1) or in a thick film shape (refer to Figs. 2 and 6), an aspect in which the photosensitive layer is provided on a surface of the blocking layer in a thin film shape or a thick film shape (refer to Fig. 3), an aspect in which the photosensitive layer is provided on a surface of the electron transport layer in a thin film shape or a thick film shape (refer to Fig. 4), and an aspect in which the photosensitive layer is provided on a surface of the hole transport layer in a thin film shape or a thick film shape (refer to Fig. 5). The photosensitive layer may be provided in a linear shape or in a dispersed pattern, but is preferably provided in a film shape.

In the photoelectric conversion element of the embodiment of the present invention, the photosensitive layer contains the light absorbing agent containing the perovskite compound and the compound represented by Formula (A-0) to be described later (hereinafter, will also be referred to as the compound A). That is, the photosensitive layer also contains the perovskite compound and the compound A.

In the present invention, the light absorbing agent (the photosensitive layer) containing the perovskite compound and the compound A means that the perovskite compound and the compound A coexist on the surface or inside of the photosensitive layer. An aspect in which the perovskite compound and the compound A coexist is not particularly limited, and examples thereof include an aspect in which the perovskite compound and the compound A coexist independently (in a free state), and an aspect in which they are aggregated, adhered, supported, adsorbed, or the like by physical or chemical interaction to form a complex. In addition, examples thereof include an aspect in which the compound A or a part thereof is incorporated into a crystal structure of the perovskite compound.

In the light absorbing agent (the photosensitive layer), in the compound A, $R^a$ or Ya among groups or salts represented by G in the formula may be dissociated or may be in the form of a salt. In a case where $R^a$ or Ya is dissociated,

the compound A generally becomes an anion. An anion of the compound A may be exchanged for an anion of an anionic atom or atomic group that forms a crystal structure of the perovskite compound.

As described above, the light absorbing agent contains the perovskite compound and the compound A, whereby the temperature change resistance of the photoelectric conversion element can be improved, and a decrease in the photoelectric conversion performance against the temperature change of the surrounding (external) environment can be effectively suppressed. The details of the reason are not yet clear, but are estimated as follows. That is, the compound A has a group (G in Formula (A-0) to be described later) having a high affinity with the perovskite compound. In a case where the photosensitive layer thermally shrinks due to temperature change, it is considered that deviation of crystal grain boundaries can be suppressed by the presence of the compound A between the surfaces of perovskite compounds or between crystal grains. In addition, in the photoelectric conversion element, another layer, preferably a hole transport layer or an electron transport layer, is laminated on the photosensitive layer. In this layer structure, a thermal shrinkage difference between the photosensitive layer and the other layers is caused by the temperature change, and interfacial peeling or interface defects are likely to occur. However, in a case where the photosensitive layer contains the compound A, it is considered that a thermal shrinkage difference between the two layers can be buffered, thereby suppressing interfacial peeling.

In general, a photoelectric conversion element or a solar cell provided which includes a photosensitive layer containing a perovskite compound tends to decrease in photoelectric conversion efficiency over time in a high-humidity environment. However, in the present invention, in a case where the photosensitive layer contains the compound A, and preferably further includes a layer containing the compound A on the photosensitive layer (preferably on the surface thereof), it is possible to suppress a decrease in photoelectric conversion efficiency over time in a high-humidity environment while maintaining temperature change resistance. Thus, it is possible to impart high moisture resistance to the photoelectric conversion element.

In the photoelectric conversion element of the embodiment of the present invention, a configuration other than a configuration defined in the present invention is not particularly limited, and it is possible to employ a configuration that is known with respect to the photoelectric conversion element and a solar cell. Respective layers, which constitute the photoelectric conversion element of the embodiment of the present invention, are designed in correspondence with the purposes thereof, and may be formed, for example, in a monolayer or multilayers. For example, the porous layer may be provided between the conductive support and the photosensitive layer (refer to Figs. 1, 2, and 6).

Hereinafter, description will be given of preferred aspects of the photoelectric conversion element of the embodiment of the present invention.

In Figs. 1 to 6, the same reference numeral represents the same constituent element (member).

Furthermore, in Figs. 1, 2, and 6, the size of fine particles which form a porous layer 12 is illustrated in a highlighted manner. These fine particles are preferably packed with each other (are vapor-deposited or in close contact with each other) in the horizontal direction and the vertical direction with respect to a conductive support 11 to form a porous structure.

In the present specification, simple description of "photoelectric conversion element 10" represents photoelectric conversion elements 10A to 10F unless otherwise stated. The same applies to a system 100 and a first electrode 1. In addition, simple description of "photosensitive layer 13" represents photosensitive layers 13A to 13C unless otherwise stated. Similarly, description of "hole transport layer 3" represents hole transport layers 3A and 3B unless otherwise stated.

Examples of a preferred aspect of the photoelectric conversion element of the embodiment of the present invention include the photoelectric conversion element 10A illustrated in Fig. 1. A system 100A illustrated in Fig. 1 is a system in which the photoelectric conversion element 10A is applied to use of a cell that allows operation means M (for example, an electric motor) to operate by an external circuit 6.

The photoelectric conversion element 10A includes a first electrode 1A, a second electrode 2, and a hole transport layer 3A between the first electrode 1A and the second electrode 2.

The first electrode 1A includes a conductive support 11 including a support 11a and a transparent electrode 11b, a porous layer 12, and a photosensitive layer 13A which contains a perovskite compound and is provided on a surface of the porous layer 12 as schematically illustrated in enlarged cross-sectional region a in which a cross-sectional region a is enlarged in Fig. 1. In addition, a blocking layer 14 is provided on the transparent electrode 11b, and the porous layer 12 is formed on the blocking layer 14. As described above, in the photoelectric conversion element 10A including the porous layer 12, it is assumed that a surface area of the photosensitive layer 13A increases, and thus charge separation and charge migration efficiency are improved.

A photoelectric conversion element 10B illustrated in Fig. 2 schematically illustrates a preferred aspect in which the photosensitive layer 13A of the photoelectric conversion element 10A illustrated in Fig. 1 is provided to be thick. In the photoelectric conversion element 10B, the hole transport layer 3B is provided to be thin. The photoelectric conversion element 10B is different from the photoelectric conversion element 10A illustrated in Fig. 1 in the film thickness of the photosensitive layer 13B and the hole transport layer 3B, but the photoelectric conversion element 10B has the same configuration as that of the photoelectric conversion element 10A except for the difference.

The photoelectric conversion element 10C illustrated in Fig. 3 schematically illustrates another preferred aspect of the photoelectric conversion element of the embodiment of the present invention. The photoelectric conversion element 10C is different from the photoelectric conversion element 10B illustrated in Fig. 2 in that the porous layer 12 is not provided, but the photoelectric conversion element 10C has the same configuration as that of the photoelectric conversion element 10B except for the difference. That is, in the photoelectric conversion element 10C, the photosensitive layer 13C is formed on the surface of the blocking layer 14 in a thick film shape. In the photoelectric conversion element 10C, the hole transport layer 3B may be provided to be thick in the same manner as in the hole transport layer 3A.

The photoelectric conversion element 10D illustrated in Fig. 4 schematically illustrates still another preferred aspect of the photoelectric conversion element of the embodiment of the present invention. The photoelectric conversion element 10D is different from the photoelectric conversion element 10C illustrated in Fig. 3 in that an electron transport layer 15 is provided instead of the blocking layer 14, but the photoelectric conversion element 10D has the same configuration as that of the photoelectric conversion element 10C except for the difference. The first electrode 1D includes the conductive support 11, and the electron transport layer 15 and the photosensitive layer 13C which are sequentially formed on the conductive support 11. The photoelectric conversion element 10D is preferable when considering that the respective layers can be formed from an organic material. According to this, the productivity of the photoelectric conversion element is improved, and thickness reduction or flexibilization becomes possible.

The photoelectric conversion element 10E illustrated in Fig. 5 schematically illustrates still another preferred aspect of the photoelectric conversion element of the embodiment of the present invention. A system 100E including the photoelectric conversion element 10E is a system that is applied to use of a cell in the same manner as in the system 100A.

The photoelectric conversion element 10E includes a first electrode 1E, a second electrode 2, and an electron transport layer 4 that is provided between the first electrode 1E and the second electrode 2. The first electrode 1E includes the conductive support 11, and a hole transport layer 16 and the photosensitive layer 13C which are formed on the conductive support 11 in this order. The photoelectric conversion element 10E is preferable when considering that respective layers can be formed from an organic material in the same manner as in the photoelectric conversion element 10D.

A photoelectric conversion element 10F illustrated in Fig. 6 schematically illustrates still another preferred aspect of the photoelectric conversion element of the embodiment of the present invention. The photoelectric conversion element 10F is different from the photoelectric conversion element 10B illustrated in Fig. 2 in that the hole transport layer 3B is not provided, but the photoelectric conversion element 10F has the same configuration as that of the photoelectric conversion element 10B except for the difference.

In the present invention, a system 100 to which the photoelectric conversion element 10 is applied functions as a solar cell as follows.

Specifically, in the photoelectric conversion element 10, light that is transmitted through the conductive support 11, or the second electrode 2 and is incident to the photosensitive layer 13 excites a light absorbing agent. The excited light absorbing agent includes high-energy electrons and can emit the electrons. The light absorbing agent, which emits high-energy electrons, becomes an oxidized substance (cation).

In the photoelectric conversion elements 10A to 10D and 10F, electrons emitted from the light absorbing agent migrate between a plurality of the light absorbing agents and reach the conductive support 11. The electrons which have reached the conductive support 11 work in the external circuit 6, and then return to the photosensitive layer 13 through the second electrode 2 (and also through the hole transport layer 3 in a case where the hole transport layer 3 is present). The light absorbing agent is reduced by the electrons which have returned to the photosensitive layer 13. Meanwhile, in the photoelectric conversion element 10E, the electrons which have emitted from the light absorbing agent reaches the second electrode 2 from the photosensitive layer 13C through the electron transport layer 4, work in the external circuit 6, and then return to the photosensitive layer 13 through the conductive support 11 and the hole transport layer 16. The light absorbing agent is reduced by the electrons which have returned to the photosensitive layer 13.

As described above, in the photoelectric conversion element 10, a cycle of excitation of the light absorbing agent and electron migration is repeated, and thus the system 100 functions as a solar cell.

In the photoelectric conversion elements 10A to 10D and 10F, a method of allowing an electron to flow from the photosensitive layer 13 to the conductive support 11 is different depending on presence or absence of the porous layer 12, a kind thereof, and the like. In the photoelectric conversion element 10 of the embodiment of the present invention, electron conduction, in which electrons migrate between the light absorbing agents, occurs. Accordingly, in the present invention, in a case where the porous layer 12 is provided, the porous layer 12 can be formed from an insulating substance other than semiconductors in the related art. In a case where the porous layer 12 is formed from a semiconductor, electron conduction, in which electrons migrate at the inside of semiconductor fine particles of the porous layer 12 or between the semiconductor fine particles, also occurs. On the other hand, in a case where the porous layer 12 is formed from an insulating substance, electron conduction in the porous layer 12 does not occur. In a case where the porous layer 12 is formed from the insulating substance, in a case of using fine particles of an aluminum oxide

($Al_2O_3$) as the fine particles of the insulating substance, a relatively high electromotive force ($V_{OC}$) is obtained.

Even in a case where the blocking layer 14 as the other layer is formed from a conductor or a semiconductor, electron conduction in the blocking layer 14 occurs. In addition, even in the electron transport layer 15, electron conduction occurs.

The photoelectric conversion elements of the embodiment of the present invention are not limited to the preferred aspects, and configurations and the like of the respective aspects may be appropriately combined between the respective aspects in a range not departing from the gist of the present invention. For example, as the configuration of the photoelectric conversion element 10C or 10D, the hole transport layer 3B may not be provided, as in the photoelectric conversion element 10F.

In the present invention, materials and respective members which are used in the photoelectric conversion element can be prepared by using a typical method except for materials and members which are defined in the present invention. In regard to the photoelectric conversion element using the perovskite compound, or the solar cell, for example, WO2016/143525A and JP2017-028093A; Nature Communications 6, 10030 (2015) and Nature Chemistry 7, 2015, 703-711; and J. Am. Chem. Soc., 2009, 131(17), p. 6050 to 6051, and Science, 338, p. 643 (2012) can be referred to.

In addition, reference can be made to materials and respective members which are used in a dye sensitized solar cell. With regard to dye sensitized solar cells, for example, reference can be made to JP2001-291534A, US4,927,721A, US4,684,537A, US5,084,365A, US5,350,644A, US5,463,057A, US5,525,440A, JP1995-249790A (JP-H7-249790A), JP2004-220974A, and JP2008-135197A.

Hereinafter, preferred aspects of members and compounds that the photoelectric conversion element of the embodiment of the present invention comprises will be explained.

<First electrode 1>

The first electrode 1 includes the conductive support 11 and the photosensitive layer 13, and functions as an operation electrode in the photoelectric conversion element 10.

It is preferable that the first electrode 1 has at least one of the porous layer 12, the blocking layer 14, the electron transport layer 15, or the hole transport layer 16 as illustrated in Figs. 1 to 6.

It is preferable that the first electrode 1 includes at least the blocking layer 14 from the viewpoint of short-circuit prevention, and more preferably the porous layer 12 and the blocking layer 14 from the viewpoints of light absorption efficiency and short-circuit prevention.

In addition, it is preferable that the first electrode 1 includes the electron transport layer 15 and the hole transport layer 16 which are formed from an organic material from the viewpoints of an improvement in productivity of the photoelectric conversion element, thickness reduction, and flexibilization.

-Conductive support 11-

The conductive support 11 is not particularly limited as long as the conductive support 11 has conductivity and can support the photosensitive layer 13 and the like. It is preferable that the conductive support 11 has a configuration formed from a conductive material, for example, a metal, or a configuration including the support 11a formed from glass or plastic and the transparent electrode 11b formed on a surface of the support 11a as a conductive film.

Among these, as illustrated in Figs. 1 to 6, it is more preferable that the conductive support 11 has a configuration in which a conductive metal oxide is applied to the surface of the support 11a formed from glass or plastic to form the transparent electrode 11b. Examples of the support 11a formed from plastic include a transparent polymer film described in Paragraph 0153 of JP2001-291534A. As a material that forms the support 11a, it is possible to use ceramic (JP2005-135902A) and a conductive resin (JP2001-160425A) in addition to glass or plastic. As a metal oxide, a tin oxide (TO) is preferable, and an indium-tin oxide (a tin-doped indium oxide: ITO) or a fluorine-doped tin oxide such as a tin oxide doped with fluorine (FTO) is particularly preferable. At this time, the amount of the metal oxide applied is preferably 0.1 to 100 g per 1 $m^2$ of a surface area of the support 11a. In a case of using the conductive support 11, it is preferable that light is incident from a support 11a side.

It is preferable that the conductive support 11 is substantially transparent. In the present invention, "substantially transparent" represents that transmittance of light (having a wavelength of 300 to 1200 nm) is 10% or greater, preferably 50% or greater, and more preferably 80% or greater.

The thickness of the support 11a and the conductive support 11 is not particularly limited and is set to an appropriate thickness. For example, the thickness is preferably 0.01 $\mu$m to 10 mm, more preferably 0.1 $\mu$m to 5 mm, and still preferably 0.3 $\mu$m to 4 mm.

In a case of providing the transparent electrode 11b, the film thickness of the transparent electrode 11b is not particularly limited. For example, the film thickness is preferably 0.01 to 30 $\mu$m, more preferably 0.02 to 25 $\mu$m, and still more preferably 0.025 to 20 $\mu$m.

The conductive support 11 or the support 11a may have a light management function on the surface. For example, the conductive support 11 or the support 11a may include an antireflection film formed by alternately laminating a high-refractive-index and a low-refractive-index oxide film on the surface of the conductive support 11 or the support 11a as described in JP2003-123859A or may have a light guide function as described in JP2002-260746A.

-Blocking layer 14-

In the present invention, as in the photoelectric conversion elements 10A to 10C and 10F, the blocking layer 14 is preferably provided on the surface of the transparent electrode 11b, that is, between the conductive support 11, and the porous layer 12, the photosensitive layer 13, the hole transport layer 3, or the like.

In the photoelectric conversion element, for example, in a case where the photosensitive layer 13 or the hole transport layer 3, and the transparent electrode 11b and the like are electrically connected to each other, a reverse current is generated. The blocking layer 14 plays a role of preventing the reverse current. The blocking layer 14 is also referred to as a "short-circuit prevention layer."

The blocking layer 14 may be allowed to function as a stage that carries the light absorbing agent.

The blocking layer 14 may be provided even in a case where the photoelectric conversion element includes the electron transport layer. For example, in a case of the photoelectric conversion element 10D, the blocking layer 14 may be provided between the conductive support 11 and the electron transport layer 15, and in a case of the photoelectric conversion element 10E, the blocking layer 14 may be provided between the second electrode 2 and the electron transport layer 4.

The material that forms the blocking layer 14 is not particularly limited as long as the material can perform the above-described function, and it is preferable that the material is a material through which visible light is transmitted, and which has insulating properties with respect to the conductive support 11 (transparent electrode 11b) and the like. Specifically, "material having insulating properties with respect to the conductive support 11 (transparent electrode 11b)" represents a compound (n-type semiconductor compound) having a conduction band energy level that is equal to or higher than a conduction band energy level of a material that forms the conductive support 11 (a metal oxide that forms the transparent electrode 11b) and is lower than a conduction band energy level of a material that constitutes the porous layer 12 or a ground state energy level of the light absorbing agent.

Examples of a material that forms the blocking layer 14 include silicon oxide, magnesium oxide, aluminum oxide, calcium carbonate, cesium carbonate, polyvinyl alcohol, polyurethane, and the like. In addition, the material may be a material that is typically used as a photoelectric conversion material, and examples thereof include titanium oxide, tin oxide, zinc oxide, niobium oxide, tungsten oxide, and the like. Among these, titanium oxide, tin oxide, magnesium oxide, aluminum oxide, and the like are preferred.

It is preferable that the film thickness of the blocking layer 14 is 0.001 to 10 μm, more preferably 0.005 to 1 μm, and still more preferably 0.01 to 0.1 μm.

In the present invention, the film thickness of each layer can be measured by observing the cross section of the photoelectric conversion element 10 using a scanning electron microscope (SEM) and the like.

-Porous layer 12-

In the present invention, as in the photoelectric conversion elements 10A, 10B, and 10F, the porous layer 12 is preferably provided on the transparent electrode 11b. In a case where the blocking layer 14 is provided, the porous layer 12 is preferably formed on the blocking layer 14.

The porous layer 12 is a layer that functions as a stage that carries the photosensitive layer 13 on the surface. In a solar cell, so as to increase the light absorption efficiency, it is preferable to increase a surface area of at least a portion that receives light such as solar light, and it is preferable to increase the surface area of the porous layer 12 as a whole.

It is preferable that the porous layer 12 is a fine particle layer that includes pores and is formed through vapor-deposition or close contact of fine particles of a material that forms the porous layer 12. The porous layer 12 may be a fine particle layer that is formed through vapor-deposition of two or more kinds of fine particles. In a case where the porous layer 12 is a fine particle layer that includes pores, it is possible to increase the amount (adsorption amount) of the carried light absorbing agent.

It is preferable to increase the surface area of individual fine particles which constitute the porous layer 12 so as to increase the surface area of the porous layer 12. In the present invention, in a state in which the fine particles are applied to the conductive support 11 and the like, it is preferable that the surface area of the fine particles which form the porous layer 12 is 10 or more times a projected area, and more preferably 100 or more times the projected area. The upper limit thereof is not particularly limited. Typically, the upper limit is approximately 5000 times the projected area. With regard to a particle size of the fine particles which form the porous layer 12, an average particle size, which

uses a diameter when converting the projected area into a circle, is preferably 0.001 to 1 μm as primary particles. In a case where the porous layer 12 is formed by using a dispersion of fine particles, the average particle size of the fine particles is preferably 0.01 to 100 μm in terms of an average particle size of the dispersion.

For the material that forms the porous layer 12, there is no particular limitation with respect to conductivity. The material may be an insulating substance (insulating material), a conductive material, or a semiconductor (semi-conductive material).

As the material that forms the porous layer 12, it is possible to use, for example, chalcogenides (for example, an oxide, a sulfide, a selenide, and the like) of metals, compounds having a perovskite-type crystal structure (excluding a perovskite compound that uses a light absorbing agent), oxides of silicon (for example, silicon dioxide, and zeolite), or carbon nanotubes (including carbon nanowires, carbon nanorods, and the like).

The chalcogenides of a metal are not particularly limited, and preferred examples thereof include respective oxides of titanium, tin, zinc, tungsten, zirconium, hafnium, strontium, indium, cerium, yttrium, lanthanum, vanadium, niobium, aluminum, and tantalum, cadmium sulfide, cadmium selenide, and the like. Examples of the crystal structure of the chalcogenides of metals include an anatase-type crystal structure, a brookite-type crystal structure, and a rutile-type crystal structure, and the anatase-type crystal structure and the brookite-type crystal structure are preferable.

The compound having a perovskite-type crystal structure is not particularly limited, and examples thereof include a transition metal oxide and the like. Examples of the transition metal oxide include strontium titanate, calcium titanate, barium titanate, lead titanate, barium zirconate, barium stannate, lead zirconate, strontium zirconate, strontium tantalate, potassium niobate, bismuth ferrate, barium strontium titanate, lanthanum barium titanate, sodium titanate, and bismuth titanate. Among these, strontium titanate, calcium titanate, and the like are preferable.

The carbon nanotubes have a shape obtained by rounding off a carbon film (graphene sheet) into a tubular shape. The carbon nanotubes are classified into a single-walled carbon nanotube (SWCNT) obtained by winding one graphene sheet in a cylindrical shape, a double-walled carbon nanotube (DWCNT) obtained by winding two graphene sheets in a concentric shape, and a multi-walled carbon nanotube (MWCNT) obtained by winding a plurality of graphene sheets in a concentric shape. As the porous layer 12, any carbon nanotubes can be used without any particular limitation.

Among these, as the material that forms the porous layer 12, an oxide of titanium, tin, zinc, zirconium, aluminum, or silicon, or a carbon nanotube is preferable, and titanium oxide or aluminum oxide is more preferable.

The porous layer 12 may be formed from at least one kind of the chalcogenides of metals, the compound having a perovskite-type crystal structure, the oxide of silicon, or the carbon nanotube, or may be formed from a plurality of kinds thereof.

The film thickness of the porous layer 12 is not particularly limited. The thickness is typically in a range of 0.05 to 100 μm, and preferably in a range of 0.1 to 100 μm. In a case of being used as a solar cell, the film thickness is preferably 0.1 to 50 μm, and more preferably 0.2 to 30 μm.

-Electron transport layer 15-

In the present invention, as in the photoelectric conversion element 10D, the electron transport layer 15 is preferably provided on the surface of the transparent electrode 11b.

The electron transport layer 15 has a function of transporting electrons, which are generated in the photosensitive layer 13, to the conductive support 11. The electron transport layer 15 is formed from an electron transporting material capable of exhibiting the above-described function. The electron transporting material is not particularly limited, and an organic material (organic electron transporting material) is preferable. Examples of the organic electron transporting material include fullerene compounds such as [6,6]-phenyl-C61-butyric acid methyl ester ($PC_{61}BM$), perylene compounds such as perylene tetracarboxylic diimide (PTCDI), low-molecular-weight compounds such as tetracyanoquinodimethane (TCNQ), high-molecular-weight compounds, or the like.

Although not particularly limited, it is preferable that the film thickness of the electron transport layer 15 is 0.001 to 10 μm, and more preferably 0.01 to 1 μm.

-Hole transport layer 16-

In the present invention, as in the photoelectric conversion element 10E, the hole transport layer 16 is preferably provided on the surface of the transparent electrode 11b. The hole transport layer 16 is the same as the hole transport layer 3 to be described later except for a different formation position.

-Photosensitive layer (light absorbing layer) 13-

The photosensitive layer 13 is preferably provided on the surface (including an inner surface of a concave portion in a case where a surface on which the photosensitive layer 13 is provided is uneven) of each of the porous layer

12 (in the photoelectric conversion elements 10A, 10B, and 10F), the blocking layer 14 (in the photoelectric conversion element 10C), the electron transport layer 15 (in the photoelectric conversion element 10D), and the hole transport layer 16 (in the photoelectric conversion element 10E).

In the present invention, the light absorbing agent is contained in the photosensitive layer 13. This light absorbing agent contains at least one perovskite compound to be described later and the compound A to be described later. Accordingly, the photosensitive layer 13 contains at least one perovskite compound to be described later and the compound A to be described later.

In addition, the photosensitive layer may have a light absorbing component such as a metal complex dye and an organic dye in addition to the above light absorbing agent.

The photosensitive layer 13 may be a monolayer or a laminate structure of two or more layers. In a case where the photosensitive layer 13 has the laminate structure of two or more layers, the laminate structure may be a laminate structure obtained by laminating layers formed from light absorbing agents different from each other, or a laminate structure including an interlayer including a hole transporting material between a photosensitive layer and a photosensitive layer. In a case where the photosensitive layer 13 is the laminate structure of two or more layers, as long as at least one layer has one kind of each of the perovskite compound to be described later and the compound A to be described later, the photosensitive layer 13 may have any layer, or may have all layers.

The aspect in which the photosensitive layer 13 is provided on the conductive support 11 is as described above. The photosensitive layer 13 is preferably provided on a surface of each of the layers in order for an excited electron to flow to the conductive support 11 or the second electrode 2. At this time, the photosensitive layer 13 may be provided on the entirety or a part of the surface of each of the layers.

The film thickness of the photosensitive layer 13 is appropriately set in correspondence with an aspect in which the photosensitive layer 13 is provided on the conductive support 11, and is not particularly limited. In general, for example, the film thickness is preferably 0.001 to 100 μm, more preferably 0.01 to 10 μm, and still more preferably 0.01 to 5 μm.

In a case where the porous layer 12 is provided, a total film thickness including the film thickness of the porous layer 12 is preferably 0.01 μm or greater, more preferably 0.05 μm or greater, still more preferably 0.1 μm or greater, and still more preferably 0.3 μm or greater. In addition, the total film thickness is preferably 100 μm or less, more preferably 50 μm or less, and even more preferably 30 μm or less. The total film thickness may be set to a range in which the above-described values are appropriately combined.

In a case where the photoelectric conversion element 10 includes the porous layer 12 and the hole transport layer 3, a total film thickness of the porous layer 12, the photosensitive layer 13, and the hole transport layer 3 is not particularly limited. For example, the total thickness is preferably 0.01 μm or greater, more preferably 0.05 μm or greater, still more preferably 0.1 μm or greater, and still more preferably 0.3 μm or greater. In addition, the total film thickness is preferably 200 μm or less, is more preferably 50 μm or less, is even more preferably 30 μm or less, and is particularly preferably 5 μm or less. The total film thickness may be set to a range in which the above-described values are appropriately combined.

In the present invention, in a case where the photosensitive layer is provided in a thick film shape (in the photosensitive layer 13B and 13C), the light absorbing agent that is included in the photosensitive layer may function as a hole transporting material.

(Light absorbing agent)

-Perovskite compound-

A light absorbing agent in the photosensitive layer 13 contains the perovskite compound having an element of Group 1 in the periodic table or a cationic organic group A, a metal atom M other than elements of Group 1 in the periodic table, and an anionic atom or atomic group X. In the perovskite compound, the element of Group 1 in the periodic table or the cationic organic group A, the metal atom M, and the anionic atom or atomic group X exists as individual constituent ions of a cation (for convenience, may be referred to as "cation A"), a metal cation (for convenience, may be referred to as "cation M"), and an anion (for convenience, may be referred to as "anion X") in the perovskite-type crystal structure. In the present invention, the cationic organic group represents an organic group having a property of becoming a cation in the perovskite-type crystal structure, and the anionic atom or atomic group represents an atom or atomic group that has a property of becoming an anion in the perovskite-type crystal structure.

In the perovskite compound that is used in the present invention, the cation A represents a cation of an element of Group 1 in the periodic table or an organic cation that is composed of a cationic organic group A. This cation A may be one kind of cation or may be two or more kinds of cations. In the case of two or more kinds of cations, the cation A may be a cation of two or more elements of Group 1 in the periodic table, may be two or more kinds of organic cations, or may include at least one cation of an element of Group 1 in the periodic table, and at least one organic cation. The

cation A preferably contains an organic cation, and more preferably contains an organic cation. An abundance ratio of each cation in the case of two or more cations is not particularly limited.

The cation of an element of Group 1 in the periodic table is not particularly limited, and examples thereof include cations ($Li^+$, $Na^+$, $K^+$, and $Cs^+$) of individual elements of lithium (Li), sodium (Na), potassium (K), and cesium (Cs), and the cation ($Cs^+$) of cesium is more preferable.

The organic cation is not particularly limited as long as the organic cation is a cation of an organic group having the above-described property, but an organic cation of a cationic organic group represented by the following Formula (A-1) is more preferable.

Formula (A-1): $R^1 - N(R^{1a})_3^+$

In Formula (1), $R^1$ represents a substituent. $R^1$ is not particularly limited as long as $R^1$ is an organic group, but an alkyl group, a cycloalkyl group, an alkenyl group, an alkynyl group, an aryl group, a heteroaryl group, an aliphatic heterocyclic group, or a group represented by Formula (2) is preferable. Among these, the alkyl group and a group represented by the following Formula (2) are more preferable.

In addition, $R^{1a}$ represents a hydrogen atom, an alkyl group, a cycloalkyl group, an alkenyl group, an alkynyl group, an aryl group, a heteroaryl group, or an aliphatic heterocyclic group. Among them, a hydrogen atom or an alkyl group is preferable, and a hydrogen atom is more preferable.

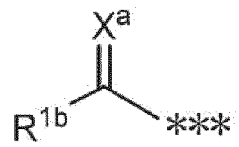

Formula (2)

In Formula (2), $X^a$ represents $NR^{1c}$, an oxygen atom, or a sulfur atom. $R^{1b}$ and $R^{1c}$ each independently represent a hydrogen atom or a substituent. *** represents a binding site with a nitrogen atom in Formula (A-1).

In the present invention, as the organic cation of the cationic organic group A, an organic ammonium cation ($R^1$-$NH_3^+$) in which $R^{1a}$ is a hydrogen atom, and which is composed of an ammonium cationic organic group A obtained through bonding between $R^1$ and $N(R^{1a})_3$ in Formula (A-1) is preferable. In a case where the organic ammonium cation can employ a resonance structure, the organic cation further includes a cation having the resonance structure in addition to the organic ammonium cation. For example, in a case where $X^a$ is NH ($R^{1c}$ is a hydrogen atom) in a group represented by Formula (2), the organic cation also includes an organic amidinium cation that is one of a resonance structure of the organic ammonium cation in addition to the organic ammonium cation of the ammonium cationic organic group obtained through bonding between the group represented by Formula (2) and $NH_3$. Examples of the organic amidinium cation composed of the amidinium cationic organic group include a cation represented by the following Formula ($A^{am}$). In the present specification, the cation represented by the following Formula ($A^{am}$) may be noted as "$R^{1b}C(=NH)-NH_3^+$" for convenience.

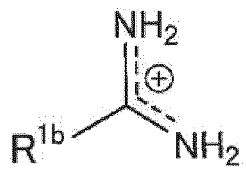

Formula ($A^{am}$)

The alkyl group as $R^1$ and $R^{1a}$ in Formula (1) is preferably an alkyl group having 1 to 36 carbon atoms, more an alkyl group having 1 to 18 carbon atoms, even more preferably an alkyl group having 1 to 6 carbon atoms, and particularly preferably an alkyl group having 1 to 3 carbon atoms. Examples of the alkyl group include methyl, ethyl, propyl, isopropyl, butyl, tert-butyl, pentyl, hexyl, and the like.

The cycloalkyl group that may be adopted as $R^1$ and $R^{1a}$ is preferably a cycloalkyl group having 3 to 10 carbon atoms, and more preferably a cycloalkyl group having 3 to 8 carbon atoms, and examples thereof include cyclopropyl, cyclopentyl, cyclohexyl, and the like.

The alkenyl group that may be adopted as $R^1$ and $R^{1a}$ is preferably an alkenyl group having 2 to 36 carbon

atoms, more preferably an alkenyl group having 2 to 18 carbon atoms, and even more preferably an alkenyl group having 2 to 6 carbon atoms. Examples of the alkenyl group include vinyl, allyl, butenyl, hexenyl, and the like.

The alkynyl group that may be adopted as $R^1$ and $R^{1a}$ is preferably an alkynyl group having 2 to 36 carbon atoms, more preferably an alkynyl group having 2 to 18 carbon atoms, and even more preferably an alkynyl group having 2 to 4 carbon atoms. Examples of the alkynyl group include ethynyl, butynyl, hexynyl, and the like.

The aryl group that may be adopted as $R^1$ and $R^{1a}$ is preferably an aryl group having 6 to 24 carbon atoms, and more preferably an aryl group having 6 to 12 carbon atoms, and examples thereof include phenyl.

The heteroaryl group that may be adopted as $R^1$ and $R^{1a}$ includes a group composed of an aromatic hetero ring alone, and a group composed of a condensed hetero ring obtained through condensing of another ring, for example, an aromatic ring, an aliphatic ring, or a hetero ring with the aromatic hetero ring. As the ring-constituting hetero atom that constitutes the aromatic hetero ring, a nitrogen atom, an oxygen atom, or a sulfur atom is preferable. In addition, with regard to the number of ring members of the aromatic hetero ring, a 3- to 8-membered ring is preferable, and a 5- or 6-membered ring is more preferable. Examples of the 5-membered aromatic hetero ring and the condensed hetero ring including the 5-membered aromatic hetero ring include respective cyclic groups of a pyrrole ring, an imidazole ring, a pyrazole ring, an oxazole ring, a thiazole ring, a triazole ring, a furan ring, a thiophene ring, a benzimidazole ring, a benzoxazole ring, a benzothiazole ring, an indoline ring, and an indazole ring. In addition, examples of the 6-membered aromatic hetero ring and the condensed hetero ring including the 6-membered aromatic hetero ring include respective cyclic groups of a pyridine ring, a pyrimidine ring, a pyrazine ring, a triazine ring, a quinoline ring, and a quinazoline ring.

The aliphatic heterocyclic groups that may be adopted as $R^1$ and $R^{1a}$ include a monocyclic group composed of an aliphatic hetero ring alone, and a group composed of a condensed aliphatic hetero ring obtained through condensing of another ring (for example, an aliphatic ring) with the aliphatic hetero ring. As the ring-constituting hetero atom that constitutes the aliphatic hetero ring, a nitrogen atom, an oxygen atom, or a sulfur atom is preferable. In addition, with regard to the number of ring members of the aliphatic hetero ring, three-membered to eight-membered rings are preferable, and a five-membered ring or a six-membered ring is more preferable. The number of carbon atoms of the aliphatic hetero ring is preferably from 0 to 24, more preferably from 1 to 18, even more preferably from 2 to 10, and particularly preferably from 3 to 5. Specific preferred examples of the aliphatic hetero ring include a pyrrolidine ring, an oxolane ring, a thiolane ring, a piperidine ring, a tetrahydrofuran ring, an oxane ring (tetrahydropyran ring), a thiane ring, a piperazine ring, a morpholine ring, a quinuclidine ring, a pyrrolidine ring, an azetidine ring, an oxetane ring, an aziridine ring, a dioxane ring, a pentamethylene sulfide ring, γ-butyrolactone, and the like.

In the group represented by Formula (2), which may be adopted as $R^1$, $X^a$ represents $NR^{1c}$, an oxygen atom, or a sulfur atom, and $NR^{1c}$ is preferable as $X^a$. $R^{1c}$ represents a hydrogen atom or a substituent. $R^{1c}$ is preferably a hydrogen atom, an alkyl group, a cycloalkyl group, an alkenyl group, an alkynyl group, an aryl group, a heteroaryl group, or an aliphatic heterocyclic group, and more preferably a hydrogen atom.

$R^{1b}$ represents a hydrogen atom or a substituent, and is preferably a hydrogen atom. As a substituent that may be adopted as $R^{1b}$, an amino group, an alkyl group, a cycloalkyl group, an alkenyl group, an alkynyl group, an aryl group, a heteroaryl group, or an aliphatic heterocyclic group may be exemplified.

An alkyl group, a cycloalkyl group, an alkenyl group, an alkynyl group, an aryl group, a heteroaryl group, or an aliphatic heterocyclic group which can be respectively employed as $R^{1b}$ and $R^{1c}$ are the same as the respective groups of $R^{1a}$, and preferred examples thereof are the same as described above.

In the present invention, an amino group may be an unsubstituted or substituted amino group, and includes an alkylamino group, an alkenylamino group, an alkynylamino group, a cycloalkylamino group, a cycloalkenylamino group, an arylamino group, and a heterocyclic amino group. The number of carbon atoms of amino is preferably 0 to 20.

Examples of the group represented by Formula (2) include a (thio)acyl group, a (thio)carbamoyl group, an imidoyl group, and an amidino group.

Examples of the (thio)acyl group include an acyl group and a thioacyl group. The acyl group is preferably an acyl group having a total of 1 to 7 carbon atoms, and examples thereof include formyl, acetyl ($CH_3C(=O)$-), propionyl, hexanoyl, and the like. The thioacyl group is preferably a thioacyl group having a total of 1 to 7 carbon atoms, and examples thereof include thioformyl, thioacetyl ($CH_3C(=S)$-), thiopropionyl, and the like.

Examples of the (thio)carbamoyl group include a carbamoyl group ($H_2NC(=O)$-) and a thiocarbamoyl group ($H_2NC(=S)$-).

The imidoyl group is a group represented by $R^{1b}$-$C(=NR^{1c})$-, and it is preferable that $R^{1b}$ and $R^{1c}$ are respectively a hydrogen atom and an alkyl group. More preferably, the alkyl group is the same as the alkyl group as $R^{1a}$. Examples thereof include formimidoyl (HC(=NH)-), acetimidoyl ($CH_3C(=NH)$-), propionimidoyl ($CH_3CH_2C(=NH)$-), and the like. Among these, formimidoyl is preferable.

An amidino group as a group that can be represented by Formula (2) has a structure (-C(=NH)$NH_2$) in which $R^{1b}$ of the imidoyl group is an amino group and $R^{1c}$ is a hydrogen atom.

The entirety of the alkyl group, the cycloalkyl group, the alkenyl group, the alkynyl group, the aryl group, the heteroaryl group, an aliphatic heterocyclic group, and the group represented by Formula (2), which can be employed

as $R^1$ and $R^{1a}$, may have a substituent. The substituent, which $R^1$ and $R^{1a}$ may have, is not particularly limited, and examples thereof include an alkyl group, a cycloalkyl group, an alkenyl group, an alkynyl group, an aryl group, a heterocyclic group (a heteroaryl group and an aliphatic heterocyclic group), an alkoxy group, an alkylthio group, an amino group (such as an alkylamino group and an arylamino group), an acyl group, an alkylcarbonyloxy group, an aryloxy group, an alkoxycarbonyl group, an aryloxycarbonyl group, an acylamino group, a sulfonamide group, a carbamoyl group, a sulfamoyl group, a halogen atom, a cyano group, a hydroxy group, and a carboxy group. The substituent, which $R^1$ and $R^{1a}$ may have, may be additionally substituted with a substituent.

In the perovskite compound that is used in the present invention, the metal cation M is not particularly limited as long as the metal cation is a cation of a metal atom other than elements of Group 1 in the periodic table and is a cation of a metal atom that can employ the perovskite-type crystal structure. Examples of the metal atom include metal atoms such as calcium (Ca), strontium (Sr), cadmium (Cd), copper (Cu), nickel (Ni), manganese (Mn), iron (Fe), cobalt (Co), palladium (Pd), germanium (Ge), tin (Sn), lead (Pb), ytterbium (Yb), europium (Eu), indium (In), titanium (Ti), and bismuth (Bi).

M may be one kind of metal cation, or two or more kinds of metal cations. Among them, the metal cation M is preferably a divalent cation, more preferably at least one selected from the group consisting of a divalent lead cation ($Pb^{2+}$), a divalent copper cation ($Cu^{2+}$), a divalent germanium cation ($Ge^{2+}$), and a divalent tin cation ($Sn^{2+}$), and is even more preferably $Pb^{2+}$ or $Sn^{2+}$, and is particularly preferably $Pb^{2+}$. In the case of two or more kinds of metal cations, a ratio of the metal cations is not particularly limited.

In the perovskite compound that is used in the present invention, the anion X represents an anion of an anionic atom or atomic group X. Preferred examples of the anion include anions of halogen atoms, and anions of individual atomic groups of $NCS^-$, $NCO^-$, $HO^-$, $NO_3^-$, $CH_3COO^-$, or $HCOO^-$. Among these, the anions of halogen atoms are more preferable. Examples of the halogen atoms include a fluorine atom, a chlorine atom, a bromine atom, an iodine atom, and the like.

The anion X may be an anion of one kind of anionic atom or atomic group, or anions of two or more kinds of anionic atoms or atomic groups. In a case where the anion X is an anion of one kind of anionic atom or atomic group, an anion of an iodine atom is preferable. On the other hand, in a case where the anion X includes anions of two or more kinds of anionic atoms or atomic groups, anions of two kinds of halogen atoms, particularly, an anion of a chlorine atom and an anion of an iodine atom are preferable. A ratio between two or more kinds of anions is not particularly limited.

As the perovskite compound that is used in the present invention, a perovskite compound, which has a perovskite-type crystal structure including the above-described constituent ions and is represented by the following Formula (I), is preferable.

Formula (I): $A_aM_mX_x$

In Formula (I), A represents an element of Group 1 in the periodic table or a cationic organic group. M represents a metal atom other than elements of Group 1 in the periodic table. X represents an anionic atom or atomic group.
a represents 1 or 2, m represents 1, and a, m, and x satisfy a relationship of $a+2m = x$.

In Formula (I), the element of Group 1 in the periodic table or the cationic organic group A forms the cation A of the perovskite-type crystal structure. Accordingly, there is no particular limitation as long as the element of Group 1 in the periodic table and the cationic organic group A are elements or groups which become the cation A and can constitute the perovskite-type crystal structure. The element of Group 1 in the periodic table or the cationic organic group A is the same as the element of Group 1 in the periodic table or the cationic organic group which is described in the cation A, and preferred examples thereof are the same as described above. A may include an element of Group 1 in the periodic table and a cationic organic group.

The metal atom M is a metal atom that forms the metal cation M of the perovskite-type crystal structure. Accordingly, the metal atom M is not particularly limited as long as the metal atom M is an atom other than elements of Group 1 in the periodic table, becomes the metal cation M, and constitutes the perovskite-type crystal structure. The metal atom M is the same as the metal atom that is described in the metal cation M, and preferred examples thereof are the same as described above.

The anionic atom or atomic group X forms the anion X of the perovskite-type crystal structure. Accordingly, the anionic atom or atomic group X is not particularly limited as long as the anionic atom or atomic group X is an atom or atomic group that becomes the anion X and can constitute the perovskite-type crystal structure. The anionic atom or atomic group X is the same as the anionic atom or atomic group which is described in the anion X, and preferred examples thereof are the same as described above.

The perovskite compound represented by Formula (I) is a perovskite compound represented by the following Formula (1-1) in a case where a is 1, or a perovskite compound represented by the following Formula (1-2) in a case where a is 2.

Formula (I-1): $AMX_3$

Formula (1-2): $A_2MX_4$

In Formula (1-1) and Formula (1-2), A represents an element of Group 1 in the periodic table or a cationic organic group. A is the same as A in Formula (I), and preferred examples thereof are the same as described above. M represents a metal atom other than elements of Group 1 in the periodic table. M is the same as M in Formula (I), and preferred examples thereof are the same as described above. X represents an anionic atom or atomic group. X is the same as X in Formula (I), and preferred examples thereof are the same as described above.

The perovskite compound that is used in the present invention may be any one of the compound represented by Formula (1-1) and the compound represented by Formula (1-2), or a mixture thereof. Accordingly, in the present invention, at least one kind of the perovskite compound may exist as the light absorbing agent, and there is no need for clear and strict distinction on that the perovskite compound is which compound by using a composition formula, a molecular formula, a crystal structure, and the like.

Hereinafter, specific examples of the perovskite compound that can be used in the present invention will be exemplified, but the present invention is not limited to the specific examples. In the following description, the perovskite compound is classified into the compound represented by Formula (I-1) and the compound represented by Formula (I-2). However, even the compound exemplified as the compound represented by Formula (I-1) may be the compound represented by Formula (I-2) in accordance with synthesis conditions, or may be a mixture of the compound represented by Formula (I-1) and the compound represented by Formula (I-2). Similarly, even the compound exemplified as the compound represented by Formula (I-2) may be the compound represented by Formula (I-1), or may be a mixture of the compound represented by Formula (I-1) and the compound represented by Formula (I-2).

Specific examples of the compound represented by Formula (1-1) include $CH_3NH_3PbCl_3$, $CH_3NH_3PbBr_3$, $CH_3NH_3PbI_3$, $CH_3NH_3PbBrI_2$, $CH_3NH_3PbBr_2I$, $CH_3NH_3SnBr_3$, $CH_3NH_3SnI_3$, $CH_3NH_3GeCl_3$, $CH(=NH)NH_3PbI_3$, $CsSnI_3$, and $CsGeI_3$.

Specific examples of the compound represented by Formula (1-2) include $(C_2H_5NH_3)_2PbI_4$, $(C_{10}H_{21}NH_3)_2PbI_4$, $(CH_2{=}CHNH_3)_2PbI_4$, $(CH{\equiv}CNH_3)_2PbI_4$, $(n\text{-}C_3H_7NH_3)_2PbI_4$, $(n\text{-}C_4H_9NH_3)_2PbI_4$, $(C_6H_5NH_3)_2PbI_4$, $(C_6H_5CH_2CH_2NH_3)_2PbI_4$, $(C_6H_3F_2NH_3)_2PbI_4$, $(C_6F_5NH_3)_2PbI_4$, $(C_4H_3SNH_3)_2PbI_4$, $(CH_3NH_3)_2CuCl_4$, $(C_4H_9NH_3)_2GeI_4$, $(C_3H_7NH_3)_2FeBr_4$. Here, $C_4H_3SNH_3$ in $(C_4H_3SNH_3)_2PbI_4$ represents aminothiophene.

The perovskite compound can be synthesized from a compound represented by the following Formula (A-3) and a compound represented by the following Formula (A-2).

Formula (A-3): AX

Formula (A-2): $MX_2$

In Formula (A-3), A represents an element of Group 1 in the periodic table, or a cationic organic group. A is the same as A in Formula (I), and preferred examples thereof are the same as described above. In Formula (A-3), X represents an anionic atom or atomic group. X is the same as X in Formula (I), and preferred examples thereof are the same as described above. The compound represented by Formula (A-3) is generally a compound in which a cation A of an element of Group 1 in the periodic table or a cationic organic group, and X of an anionic atom or atomic group are ionically bonded.

In Formula (A-2), M represents a metal atom other than elements of Group 1 in the periodic table. M is the same as M in Formula (I), and preferred examples thereof are the same as described above. In Formula (A-2), X represents an anionic atom or atomic group. X is the same as X in Formula (I), and preferred examples thereof are the same as described above. The compound represented by Formula (A-2) is generally a compound in which a cation M of a metal atom other than elements of Group 1 in the periodic table, and X of an anionic atom or atomic group are ionically bonded.

Examples of a method for synthesizing the perovskite compound include the method described in WO2016/143525A and JP2017-028093A; and Nature Communications 6, 10030 (2015) and Nature Chemistry 7, 2015, 703-711. Examples thereof include methods which are described in Akihiro Kojima, Kenjiro Teshima, Yasuo Shirai, and Tsutomu Miyasaka, "Organometal Halide Perovskites as Visible-Light Sensitizers for Photovoltaic Cells," J. Am. Chem. Soc., 2009, 131(17), p. 6050 to 6051.

The amount of the perovskite light absorbing agent used may be set to an amount capable of covering at least a part of a surface of the first electrode 1, and preferably an amount capable of covering the entirety of the surface.

The amount of the perovskite compound contained in the photosensitive layer 13 is typically 1% to 100% by mass.

-Compound represented by Formula (A-0)-

The light absorbing agent includes the compound represented by Formula (A-0). This compound A imparts high temperature change resistance to the photoelectric conversion element in a case of being used in combination with the perovskite compound. The compound A preferably does not have an amino group in a molecule (excluding a nitrogen atom forming an aliphatic ring or an aromatic ring (a cyclic amino group that can be an aliphatic heterocyclic group or an aromatic heterocyclic group to be described later that can be adopted as L), and amino groups combined with other functional groups, such as amino groups in carbamoyl groups).

Formula (A-0) (G)p-L

In Formula (A-0), L represents an aliphatic hydrocarbon group, an aromatic hydrocarbon group, an aromatic heterocyclic group, or an aliphatic heterocyclic group.

Examples of aliphatic hydrocarbon groups that can be adopted as L include a saturated aliphatic hydrocarbon group and an unsaturated aliphatic hydrocarbon group. Examples of saturated aliphatic hydrocarbon groups include a group composed of a methane hydrocarbon (alkane). Examples of unsaturated aliphatic hydrocarbon groups include groups having at least one carbon-carbon unsaturated bond at the inside or at the end, a group consisting of an ethylene hydrocarbon (alkene), or a group consisting of an acetylene hydrocarbon (alkyne). The saturated aliphatic hydrocarbon group and the unsaturated aliphatic hydrocarbon group may be linear, branched or cyclic, respectively. Examples of the linear and branched aliphatic hydrocarbon groups include a linear aliphatic hydrocarbon or a group obtained by removing p hydrogen atoms from a branched aliphatic hydrocarbon. The number of carbon atoms of the linear aliphatic hydrocarbon group and the branched aliphatic hydrocarbon group is not particularly limited, but is preferably 1 to 36, more preferably 1 to 18, and even more preferably 1 to 12. Examples of cyclic aliphatic hydrocarbon groups include a group obtained by removing p hydrogen atoms from a cyclic aliphatic hydrocarbon. The cyclic aliphatic hydrocarbon may be monocyclic or polycyclic. Examples of polycycles include a condensed ring, a spiro ring or a bridged ring, and a condensed ring or a bridged ring is preferable. The number of carbon atoms of the cyclic aliphatic hydrocarbon group is not particularly limited, but is preferably 3 to 36, more preferably 3 to 18, and even more preferably 5 to 10. Examples of cyclic aliphatic hydrocarbon groups include a group consisting of a single ring such as a cycloheptane ring, a cyclohexane ring, a cycloheptin ring, or a cyclohexene ring, and a group consisting of a bridging ring such as a norbornene ring, a norbornane ring, or an adamantane ring.

The aliphatic hydrocarbon group is preferably a linear or branched saturated aliphatic hydrocarbon group.

Examples of the aromatic hydrocarbon group that can be adopted as L include groups in which p hydrogen atoms have been removed from an aromatic hydrocarbon ring. The aromatic hydrocarbon group is not particularly limited, and is preferably an aromatic hydrocarbon group having 6 to 22 carbon atoms, more preferably an aromatic hydrocarbon group having 6 to 18 carbon atoms, and even more preferably an aromatic hydrocarbon group having 6 to 10 carbon atoms. As the aromatic hydrocarbon group, a benzene ring group, a naphthalene ring group, or an aromatic hydrocarbon ring group condensed with 3 or more rings (preferably 3 to 6 rings) is more preferable. Examples of aromatic hydrocarbon ring groups condensed with three or more rings include a fluorene ring group, an anthracene ring group, a phenanthrene ring group, a chrysene ring group, and a pyrene ring group.

The aromatic hydrocarbon group is particularly preferably a benzene ring group or a naphthalene ring group.

Examples of aromatic heterocyclic groups that can be adopted as L include groups in which p hydrogen atoms have been removed from the aromatic heterocyclic ring. The aromatic heterocyclic group is not particularly limited, but preferably contains at least one nitrogen atom, oxygen atom, sulfur atom, phosphorus atom, silicon atom or selenium atom as a ring-constituting hetero atom. The aromatic heterocyclic group may be a monocyclic group or a condensed ring group of two or more rings. In the case of a monocyclic group, the number of ring members is preferably 5 to 7 members, more preferably 5 or 6 members. The number of carbon atoms in the aromatic heterocyclic ring is not particularly limited, but is preferably 0 to 22, more preferably 0 to 10, and even more preferably 1 to 6.

Examples of the 5-membered aromatic heterocyclic group include each ring group composed of a pyrrole ring, an imidazole ring, a pyrazole ring, an oxazole ring, a thiazole ring, a triazole ring, a furan ring, and a thiophene ring. In addition, examples of condensed ring groups containing a 5-membered aromatic heterocyclic ring include each ring group composed of a benzimidazole ring, a benzoxazole ring, a benzothiazole ring, an indoline ring, or an indazole ring. Furthermore, examples of the 6-membered aromatic heterocyclic group include each ring group composed of a pyridine ring, a pyrimidine ring, a pyrazine ring, or a triazine ring. Furthermore, examples of condensed ring groups containing a 6-membered aromatic heterocyclic group include each ring group composed of a quinoline ring and a quinazoline ring.

Examples of aliphatic heterocyclic groups that can be adopted as L include a group in which p hydrogen atoms have been removed from an aliphatic heterocyclic ring (aliphatic hetero ring). The aliphatic heterocyclic group is not particularly limited, but preferably contains at least one nitrogen atom, oxygen atom, sulfur atom, phosphorus atom, silicon atom or selenium atom as a ring-constituting hetero atom. The aliphatic heterocyclic group may be a monocyclic

group or a condensed ring group of two or more rings. In the case of a monocyclic group, the number of ring members is preferably 5 to 7 members, more preferably 5 or 6 members. The number of carbon atoms in the aliphatic heterocyclic group is not particularly limited, but is preferably 0 to 22, more preferably 0 to 10, and even more preferably 1 to 6.

Examples of aliphatic heterocyclic groups include each ring group composed of a pyrrolidine ring, an oxolane ring (a tetrahydrofuran ring), a thiolane ring (a tetrahydrothiophene ring), a piperidine ring, an oxane ring (a tetrahydropyran ring), a thiane ring (a tetrahydrothiopyran ring), a piperazine ring, a morpholine ring, a quinuclidine ring, a pyrrolidine ring, an azetidine ring, an oxetane ring, an aziridine ring, or a dioxane ring.

Among these, L is preferably an aliphatic hydrocarbon group or an aromatic hydrocarbon group, and more preferably an aliphatic hydrocarbon group. In particular, in a case where p is 1, L is preferably an alkyl group or an aryl group, and more preferably an alkyl group.

L may have a substituent. The substituent that L may have is not particularly limited as long as it is a group other than an amino group, and is preferably a substituent selected from the following group $L^{SG}$. The amino group not having a substituent has the same meaning as the amino group preferably not having the compound A, and examples thereof include an unsubstituted amino group, a mono- or di-alkylamino group, a mono- or di-arylamino group, a mono- or di-heterocyclic amino group.

<Group $L^{SG}$>

An alkyl group, an alkenyl group, an alkynyl group, an aryl group, an alkoxy group, an aryloxy group, a heteroaryloxy group, an alkylthio group, an arylthio group, a heteroarylthio group, an alkoxycarbonyl group, an aryloxycarbonyl group, a heteroaryloxycarbonyl group, an alkylthiocarbonyl group, an arylthiocarbonyl group, a heteroarylthiocarbonyl group, an alkylcarbonyloxy group, an arylcarbonyloxy group, a heteroarylcarbonyloxy group, an alkylcarbonylthio group, an arylcarbonylthio group, a heteroarylcarbonylthio group, a hydroxy group, a mercapto group, an acyl group, a halogen atom, a cyano group, a silyl group, a heteroaryl group, an aliphatic heterocyclic group, and a carbamoyl group

In the present invention, in a case where an alkyl group is described separately from a cycloalkyl group, the alkyl group is used to include a linear alkyl group and a branched alkyl group. On the other hand, when an alkyl group is not described separately from a cycloalkyl group (when simply described as an alkyl group), and unless otherwise specified, an alkyl group is a linear alkyl group or a branched alkyl group And cycloalkyl group. The same applies to a compound containing a group (an alkoxy group, an alkylthio group, an alkenyloxy group, and the like) containing a group that may adopt a cyclic structure (an alkyl group, an alkenyl group, an alkynyl group, and the like), or a group that may adopt a cyclic structure. In the following description of the substituent group $L^{SG}$, the alkyl group is described as a group including a cycloalkyl group, unless otherwise specified.

An alkyl group (including a cycloalkyl group), an alkenyl group, an alkynyl group, an aryl group, a heteroaryl group, and an aliphatic heterocyclic group that can be adopted as the group $L^{SG}$ are not particularly limited, and are synonymous with each corresponding group in $R^1$ described above, and a preferable range thereof is also the same.

An acyl group preferably has 1 to 19 carbon atoms, and more preferably 2 to 19 carbon atoms. Preferable specific examples of acyl groups include formyl, acetyl, propionyl, butanoyl, octadecanoyl, benzoyl, or acrylyl.

As a halogen atom, a fluorine atom, a chlorine atom, a bromine atom, or an iodine atom is exemplified, and an iodine atom or a bromine atom is preferable.

As the carbamoyl group, an N,N-disubstituted carbamoyl group is preferable, and a carbamoyl group in which an N atom is substituted with any of an alkyl group, an alkenyl group, an alkynyl group, an aryl group, a heteroaryl group, and an aliphatic heterocyclic group is more preferable. In particular, an N,N-dialkyl or diarylcarbamoyl group is preferable. Preferable specific examples of carbamoyl groups include N,N-dimethylcarbamoyl and N,N-diphenylcarbamoyl.

A silyl group is not particularly limited, but is preferably a silyl group having 1 to 20 carbon atoms, and a silyl group in which an alkyl group, an aryl group, an alkoxy group, or an aryloxy group is substituted.

In the present invention, among groups which can be adopted as the group $L^{SG}$, an alkoxy group, an aryloxy group, a heteroaryloxy group, an alkylthio group, an arylthio group, a heteroarylthio group, an alkoxycarbonyl group, an aryloxycarbonyl group, a heteroaryloxycarbonyl group, an alkylthiocarbonyl group, an arylthiocarbonyl group, a heteroarylthiocarbonyl group, an alkylcarbonyloxy group, an arylcarbonyloxy group, a heteroarylcarbonyloxy group, an alkylcarbonylthio group, an arylcarbonylthio group, and a heteroarylcarbonylthio group can be respectived represented by any of Formulas (W-1) to (W-6).

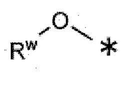
(W-1)

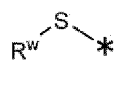
(W-2)

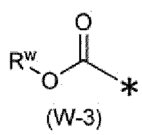
(W-3)

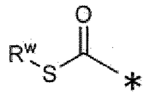
(W-4)

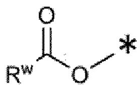
(W-5)

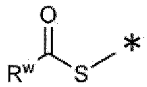
(W-6)

In Formulas (W-1) to (W-6), * represents a linking portion with L in Formula (A-0), or another substituent selected from group $L^{SG}$.

$R^w$ represents any of an alkyl group, an aryl group, and a heteroaryl group. Each of an alkyl group, an aryl group, and a heteroaryl group has the same meaning as the alkyl group (including the cycloalkyl group), aryl group and heteroaryl group in $R^1$, and a preferable range thereof is also the same.

Table 1 shows a correspondence relationship between each of the substituents included in the group $L^{SG}$ and the groups represented by Formulas (W-1) to (W-6).

[Table 1]

| Substituent included in substituent group $L^{SG}$ | General Formula | $R^w$ |
|---|---|---|
| Alkoxy group | W-1 | Alkyl |
| Aryloxy group | W-1 | Aryl |
| Heteroaryloxy group | W-1 | Heteroaryl |
| Alkylthio group | W-2 | Alkyl |
| Arylthio group | W-2 | Aryl |
| Heteroarylthio group | W-2 | Heteroaryl |
| Alkoxycarbonyl group | W-3 | Alkyl |
| Aryloxycarbonyl group | W-3 | Aryl |
| Heteroaryloxycarbonyl group | W-3 | Heteroaryl |
| Alkylthiocarbonyl group | W-4 | Alkyl |
| Arylthiocarbonyl group | W-4 | Aryl |
| Heteroarylthiocarbonyl group | W-4 | Heteroaryl |
| Alkylcarbonyloxy group | W-5 | Alkyl |
| Arylcarbonyloxy group | W-5 | Aryl |
| Heteroarylcarbonyloxy group | W-5 | Heteroaryl |
| Alkylcarbonylthio group | W-6 | Alkyl |
| Arylcarbonylthio group | W-6 | Aryl |
| Heteroarylcarbonylthio group | W-6 | Heteroaryl |

In the present invention, the group $L^{SG}$ includes, in addition to the above groups, a group in which a carbonyl group (> C=O) is changed to a thiocarbonyl group (> C=S) in Formulas (W-3) to (W-6) is also included. Specific examples thereof include an alkoxythiocarbonyl group, an aryloxythiocarbonyl group, a heteroaryloxythiocarbonyl group, an alkylthio-thiocarbonyl group, an arylthio-thiocarbonyl group, a heteroarylthio-thiocarbonyl group, an alkylthiocarbonyloxy group, an arylthiocarbonyloxy group, a heteroarylthiocarbonyloxy group, an alkylthiocarbonylthio group, an arylthiocarbonylthio group, and a heteroarylthiocarbonylthio group.

As substituents selected from the group $L^{SG}$, an alkyl group, an alkenyl group, an alkynyl group, an aryl group, an alkoxy group, an alkylthio group, an alkoxycarbonyl group, an arylthiocarbonyl group, a halogen atom, a heteroaryl group, an aliphatic heterocyclic group, and a carbamoyl group are preferable, and an alkyl group, an aryl group, a heteroaryl group, and an aliphatic heterocyclic group are more preferable.

The substituent selected from the group $L^{SG}$ may further have a substituent. In addition, the substituent that may be included is not particularly limited, and preferable examples thereof include a substituent selected from the above-mentioned group $L^{SG}$. Furthermore, a preferable range of the substituent which may be included is the same as the preferable range of the group $L^{SG}$.

In a case where the substituent selected from the group $L^{SG}$ further has a substituent, the number of substituents to be combined is not particularly limited. For example, the number of substituents is preferably 2 to 6, and is more preferably 2 or 3. Furthermore, in a case where the substituent contains a halogen atom, the number of substituents is preferably 2 to 19, and is more preferably 2 to 13.

In Formula (A-0), G represents a group or a salt selected from the group consisting of $-SO_3R^a$, $-SO_3^-Ya^+$, $-P(=O)(OR^a)_2$, $-P(=O)(O^-Ya^+)_2$, $-P(=O)R^G(OR^a)$, $-P(=O)R^G(O^-Ya^+)$, $-B(OR^a)_2$, $-OB(OR^a)_2$, and $-B(OR^a)_3^-Ya^+$.

In each of the above groups or salts, $R^a$ represents a hydrogen atom or a substituent, and is preferably a hydrogen atom. The substituent that can be adopted as $R^a$ is not particularly limited, and it is preferably a group other than an amino group, is more preferably, an alkyl group (the carbon number is preferably 1 to 25, more preferably 1 to 16, and even more preferably 1 to 8), an aryl group (the carbon number is preferably 6 to 12, and more preferably 6 to 10), a cycloalkyl group (the carbon number is preferably 3 to 7, and more preferably 3 to 6), an alkenyl group (the carbon number is preferably 2 to 16, and more preferably 3 to 8) or an alkynyl group (the carbon number is preferably 2 to 16, and more preferably 3 to 8). In each group or salt, $R^a$ may be the same as or different from each other. In $-P(=O)(OR^a)_2$, $-B(OR^a)_2$, and $-OB(OR^a)_2$, one $R^a$ can also take a counter salt Ya.

$R^G$ represents a substituent. The substituent that can be adopted as $R^G$ is not particularly limited, and is the same as the substituent that can be adopted as $R^a$, and a preferable range thereof is also the same.

Ya represents a counter salt. A counter salt Ya is not particularly limited, and examples thereof include various cations or anions. Examples of the cation include lithium ion ($Li^+$), cesium ion ($Cs^+$), sodium ion ($Na^+$), potassium ion ($K^+$), silver ion ($Ag^+$), copper ion ($Cu^+$), ammonium ion ($NR^d_4{}^+$), phosphonium ion ($PR^d_4{}^+$), and the like. $R^d$ represents a hydrogen atom or a substituent. The substituent that can be adopted as $R^d$ has the same meaning as the substituent that can be adopted as $R^a$. Examples of the anion include halide ion (fluoride ion ($F^-$), iodide ion ($I^-$), bromide ion ($Br^-$), chloride ion ($Cl^-$), and the like), $O^{2-}$, and the like. Among these, halide ion is preferable, and iodide ion ($I^-$) is more preferable.

$R^a$ and Ya may take a dissociated form as described above, or may be a salt form. In addition, they may be incorporated in the perovskite-type crystal structure.

G is preferably a group selected from the group consisting of $-SO_3R^a$, $-SO_3^-Ya^+$, $-P(=O)(OR^a)_2$, $-P(=O)(O^-Ya^+)_2$, $-B(OR^a)_2$, $-OB(OR^a)_2$, and $-B(OR^a)_3^-Ya^+$, is more preferably a group selected from the group consisting of $-SO_3R^a$, $-SO_3^-Ya^+$, $-P(=O)(OR^a)_2$, and $-P(=O)(O^-Ya^+)_2$, and is more preferably a group selected from the group consisting of $-P(=O)(OR^a)_2$ or $-P(=O)(O^-Ya^+)_2$.

In a case where the compound A has a plurality of G's, the plurality of G's may be the same as or different from each other.

In Formula (A-0), a combination of L and G is not particularly limited, and examples thereof include a combination of a preferable L and a preferable G.

An atom (position) at which G is bonded to L is not particularly limited.

In Formula (A-0), p is an integer of 1 or more, preferably an integer of 1 to 6, more preferably an integer of 1 to 4, and even more preferably 1 or 2.

Hereinafter, specific examples of the compound A that can be used in the present invention will be exemplified, but the present invention is not limited to the specific examples. In the following examples, Et represents ethyl.

A1
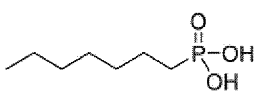
A2
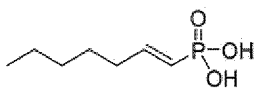
A3
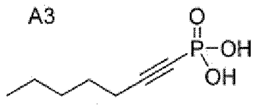

A4
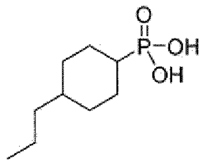
A5
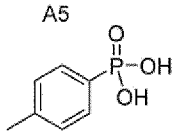
A6
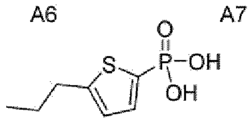
A7
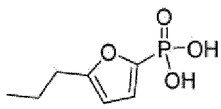

A8
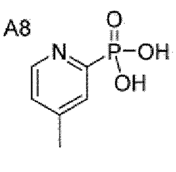
A9
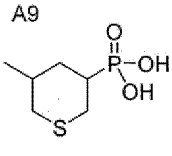
A10
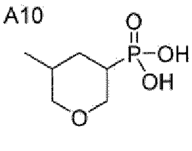
A11
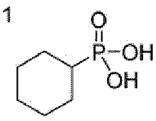

A12
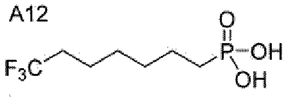
A13
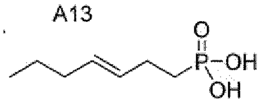
A14
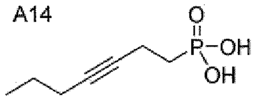

A15
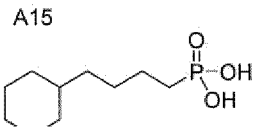
A16
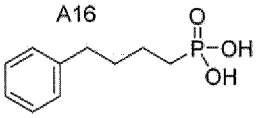
A17
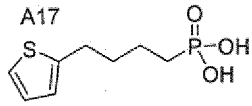

A18
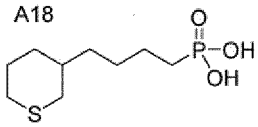
A19
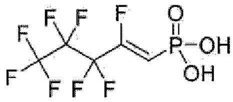
A20
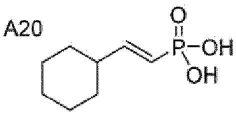

A21
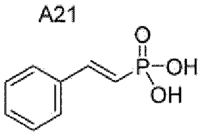
A22
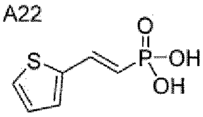
A23
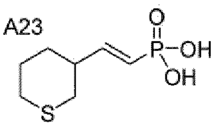

A24
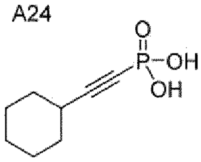
A25
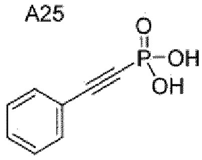
A26
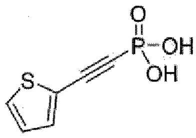
A27
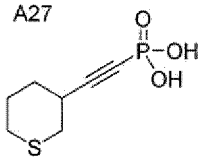

A28
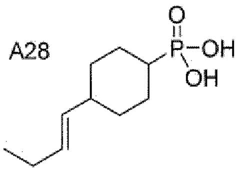
A29
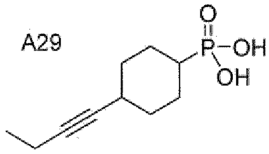
A30
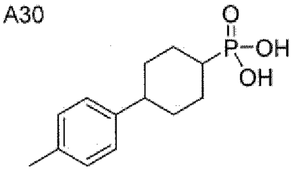

A31
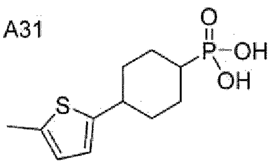
A32
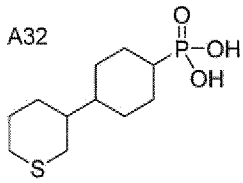
A33
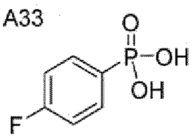

A34
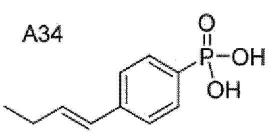
A35
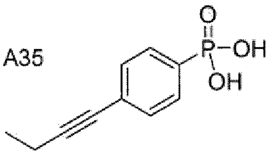
A36
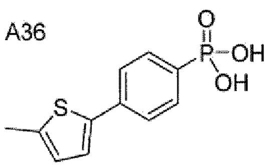

A37
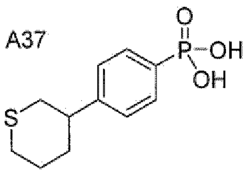
A38
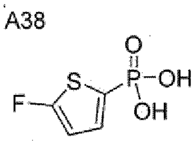
A39
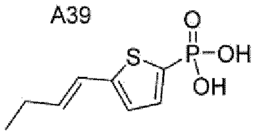

A40
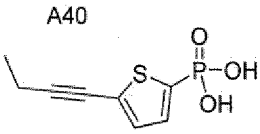
A41
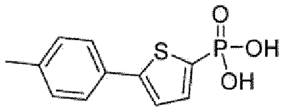
A42
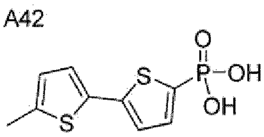

A43
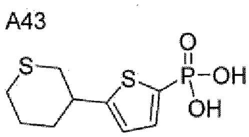
A44
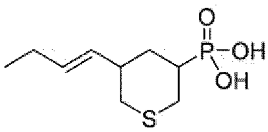
A45
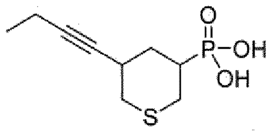

A46
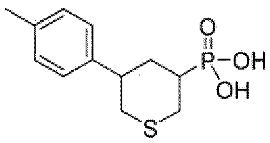
A47
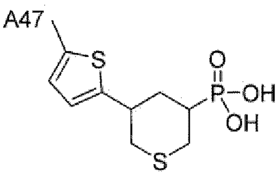

A48
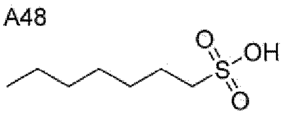
A49
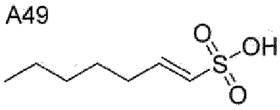
A50
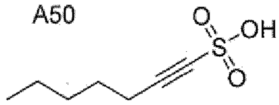

A51
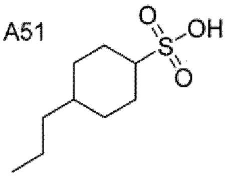
A52
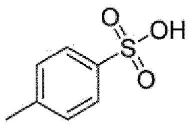
A53
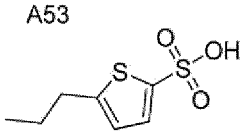
A54
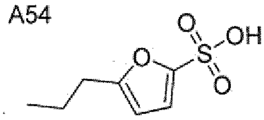

A55
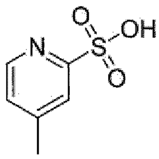
A56
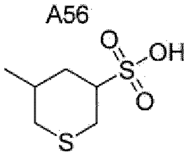
A57
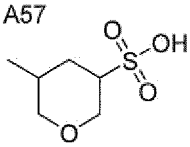
A58
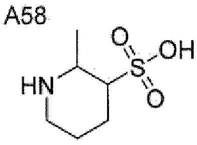

A59
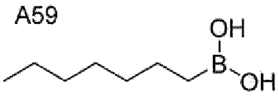
A60
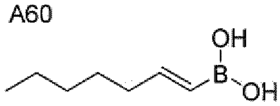
A61
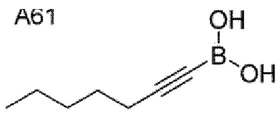

A62
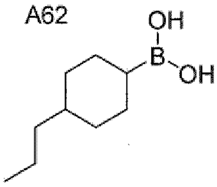
A63
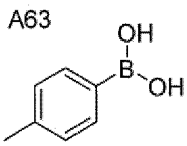
A64
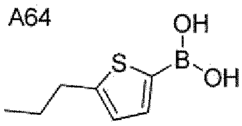
A65
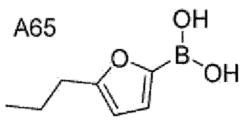

A66
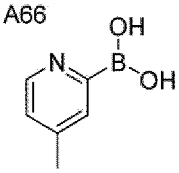

A67
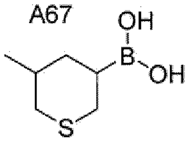

A68
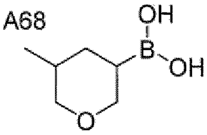

A69
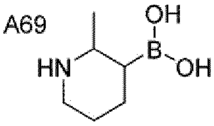

A70
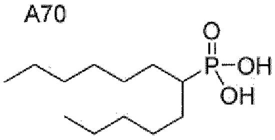

A71
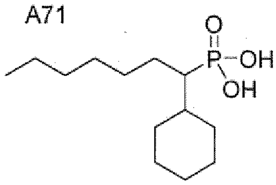

A72
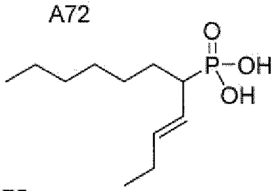

A73
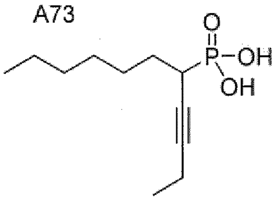

A74
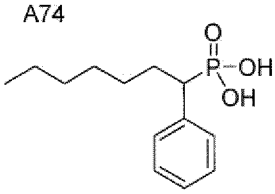

A75
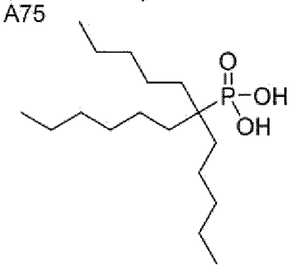

A76
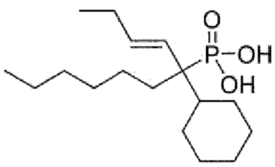

A77
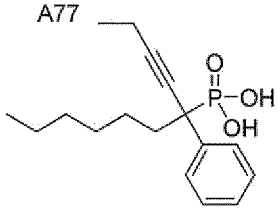

A78
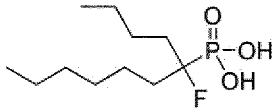

A79
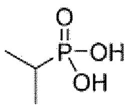

A80
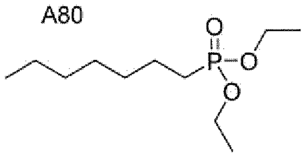

A81
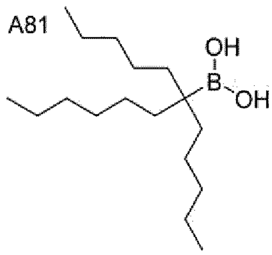

A82
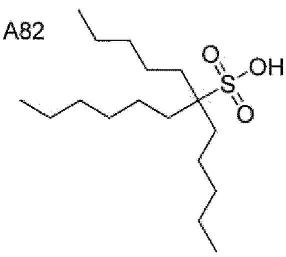

A83
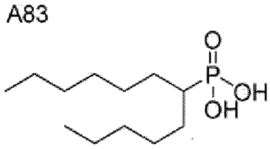

A84
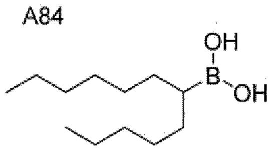

A85
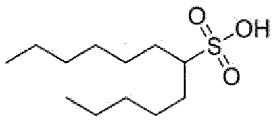

A86
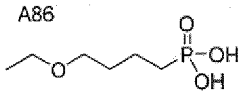

A87
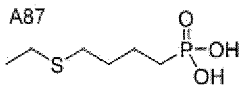

A88
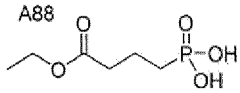

A89
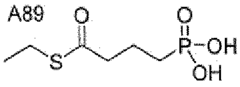
A90
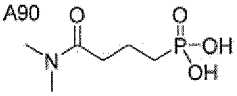
A91
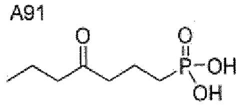

A92
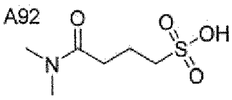
A93
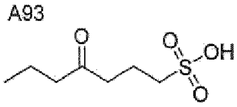
A94
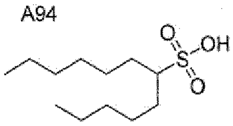

A95
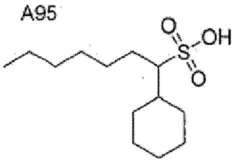
A96
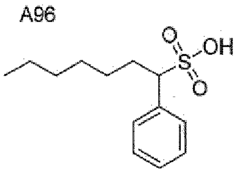
A97
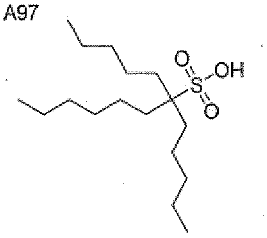

A98
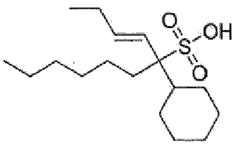
A99
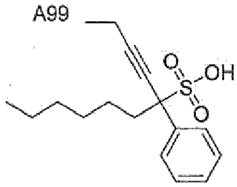
A100
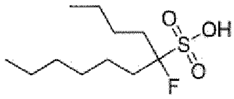

A101
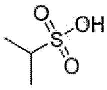
A102
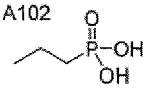

A103
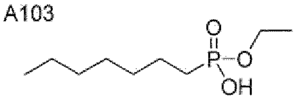
A104
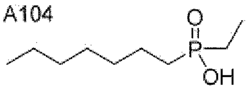
A105
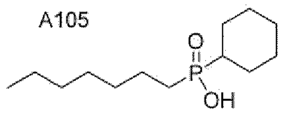

A106
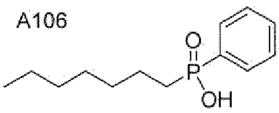
A107
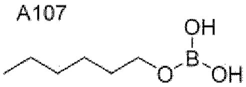
A108
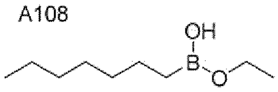

A109
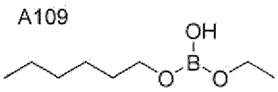
A110
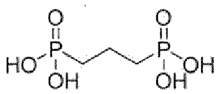
A111
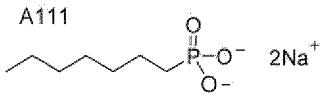

In the photosensitive layer (the light absorbing agent), a molar ratio of a content of the compound A [$M^{PCA}$] and a content of the metal atom cation M [$M^{PMC}$] is not particularly limited, and the molar ratio is preferably within the following range from the viewpoint of temperature change resistance.

[$M^{PCA}$]:[$M^{PMC}$] = 4:1 to 1:10000

The above molar ratio is more preferably within the following range.

[$M^{PCA}$]:[$M^{PMC}$] = 1:10 to 1:1000

The above molar ratio is even more preferably within the following range.

[$M^{PCA}$]:[$M^{PMC}$] = 1:50 to 1:800

In the above molar ratio, the content of the metal atom cation M is the content of the metal cation M forming a perovskite-type crystal structure, and the content of the metal cation excessively contained in the photosensitive layer is not taken into consideration.

In a case where the photosensitive-layer-forming composition to be described later is used, a molar ratio can

be calculated from each content in the photosensitive-layer-forming composition. Meanwhile, in a photoelectric conversion element or a solar cell, the photosensitive layer is quantified by X-ray photoelectron spectroscopy. Furthermore, each compound extracted from the photosensitive layer based on a general method is quantified by nuclear magnetic resonance spectrum (NMR), high-performance liquid chromatography (HPLC), gas chromatography (GC) or wave inductively coupled plasma emission spectroscopy (ICP), or a combination thereof, and thereby a moral ratio can be calculated.

<Layer containing compound A>

The photoelectric conversion element of the embodiment of the present invention preferably has a layer containing the compound A (will also be referred to as a surface treatment layer) on the surface of the photosensitive layer. The compound A is as described above.

It is sufficient for the compound A being present on the surface of the photosensitive layer. Examples of presence states include a film shape, a linear shape, a dispersed state, a state in which these are mixed, and the like. This layer does not necessarily have to form a layer or film that uniformly covers the surface of the photosensitive layer.

The layer containing the compound A can be formed by surface-treating the photosensitive layer, and is generally a thin film (for example, a film thickness of 5 nm or less).

<Hole transport layer 3>

In the photoelectric conversion element of the embodiment of the present invention, as in the photoelectric conversion elements 10A to 10D, an aspect in which the hole transport layer 3 is provided between the first electrode 1 and the second electrode 2 is also preferable. In the aspect, it is preferable that the hole transport layer 3 is in contact with (laminated on) the photosensitive layer 3C. The hole transport layer 3 is preferably provided between the photosensitive layer 13 of the first electrode 1 and the second electrode 2.

The hole transport layer 3 includes a function of supplementing electrons to an oxidized substance of the light absorbing agent, and is preferably a solid-shaped layer (solid hole transport layer).

A hole transporting material forming the hole transport layer 3 may be a liquid material or a solid material without any limitation as long as it exhibits the above functions. Examples of the hole transporting material include inorganic materials such as CuI and CuNCS, organic hole transporting materials described in paragraphs 0209 to 0212 of JP2001-291534A, and the like. Preferred examples of the organic hole transporting material include conductive polymers such as polythiophene, polyaniline, polypyrrole, and polysilane, spiro compounds in which two rings share a central atom such as C or Si having a tetrahedral structure, aromatic amine compounds such as triarylamine, triphenylene compounds, nitrogen-containing heterocyclic compounds, and liquid-crystalline cyano compounds.

As the hole transporting material, an organic hole transporting material which can be applied in a solution state and then has a solid shape is preferable, and specific examples thereof include 2,2',7,7'-tetrakis-(N,N-di-p-methoxyphenylamino)-9,9'-spirobifluorene (also referred to as spiro-MeOTAD), poly(3-hexylthiophene-2,5-diyl), 4-(diethylamino)benzaldehyde diphenylhydrazone, polyethylene dioxythiophene (PEDOT), and the like.

Although not particularly limited, the film thickness of the hole transport layer 3 is preferably 50 $\mu$m or less, more preferably 1 nm to 10 $\mu$m, still more preferably 5 nm to 5 $\mu$m, and still more preferably 10 nm to 1 $\mu$m. In addition, the film thickness of the hole transport layer 3 corresponds to an average distance between the second electrode 2 and the surface of the photosensitive layer 13, and can be measured by observing a cross-section of the photoelectric conversion element by using a scanning electron microscope (SEM) and the like.

<Electron transport layer 4>

In the photoelectric conversion element of the embodiment of the present invention, as in the photoelectric conversion element 10E, an aspect in which the electron transport layer 4 is provided between the first electrode 1 and the second electrode 2 is also preferable. In the aspect, it is preferable that the electron transport layer 4 is in contact with (laminated on) the photosensitive layer 3C.

The electron transport layer 4 is the same as the electron transport layer 15, except that a destination of electrons is the second electrode and positions where the electrons are formed are different.

<Second electrode 2>

The second electrode 2 functions as a positive electrode in a solar cell. The second electrode 2 is not particularly limited as long as the second electrode 2 has conductivity. Typically, the second electrode 2 can be configured to have the same configuration as that of the conductive support 11. In a case where sufficient strength is maintained, the support

11a is not necessary.

As a structure of the second electrode 2, a structure having a high current-collection effect is preferable. At least one of the conductive support 11 or the second electrode 2 is preferably substantially transparent so that light reaches the photosensitive layer 13. In the solar cell of the embodiment of the present invention, it is preferable that the conductive support 11 is transparent and solar light and the like is incident from the support 11a side. In this case, it is more preferable that the second electrode 2 has a light-reflecting property.

Examples of a material used to form the second electrode 2 include metals such as platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al), the above-described conductive metal oxides, carbon materials, conductive polymers, and the like. The carbon materials may be conductive materials formed through bonding of carbon atoms, and examples thereof include fullerene, a carbon nanotube, graphite, graphene, and the like. The carbon materials may be conductive materials formed through bonding of carbon atoms, and examples thereof include fullerene, a carbon nanotube, graphite, graphene, and the like.

As the second electrode 2, a thin film (including a thin film obtained through vapor-deposition) of a metal or a conductive metal oxide, or a glass substrate or a plastic substrate which has the thin film is preferable. As the glass substrate or the plastic substrate, glass including a gold or platinum thin film or glass on which platinum is vapor-deposited is preferable.

The film thickness of the second electrode 2 is not particularly limited, and is preferably 0.01 to 100 μm, more preferably 0.01 to 10 μm, and still more preferably 0.01 to 1 μm.

<Other configurations>

In the present invention, a spacer or a separator can also be used instead of the blocking layer 14 and the like or in combination with the blocking layer 14 and the like so as to prevent the first electrode 1 and the second electrode 2 from coming into contact with each other.

In addition, a hole blocking layer may be provided between the second electrode 2 and the hole transport layer 3.

[Solar cell]

The solar cell of the embodiment of the present invention is constituted by using the photoelectric conversion element of the embodiment of the present invention. For example, as illustrated in Figs. 1 to 6, the photoelectric conversion element 10 having a configuration, which is allowed to operate by the external circuit 6, can be used as the solar cell. As the external circuit 6 that is connected to the first electrode 1 (the conductive support 11) and the second electrode 2, a known circuit can be used without particular limitation.

For example, the present invention is applicable to individual solar cells described in WO2016/143525A and JP2017-028093A; Nature Communications 6, 10030 (2015) and Nature Chemistry 7, 2015, 703-711; and J. Am. Chem. Soc., 2009, 131(17), p. 6050 to 6051, and Science, 338, p. 643(2012).

It is preferable that a lateral surface of the solar cell of the embodiment of the present invention is sealed with a polymer, an adhesive, and the like so as to prevent deterioration, evaporation, and the like in constituent substances.

[Method for manufacturing photoelectric conversion element and solar cell]

Other than formation of the photosensitive layer, and the layer containing the compound A, the photoelectric conversion element and the solar cell of the embodiment of the present invention can be manufactured in accordance with a known method, for example, a method described in WO2016/143525A and JP2017-028093A; Nature Communications 6, 10030 (2015) and Nature Chemistry 7, 2015, 703-711; and J. Am. Chem. Soc., 2009, 131(17), p. 6050 to 6051, Science, 338, p. 643(2012); and the like.

The photoelectric conversion element of the embodiment of the present invention is preferably manufactured by a method for manufacturing a photoelectric conversion element of the embodiment of the present invention, the method including a step of applying, on the conductive support, a photosensitive-layer-forming composition which contains a perovskite precursor compound for forming the above-described perovskite compound, which contains the above-described compound A.

In the method for manufacturing a photoelectric conversion element of the embodiment of the present invention, the case in which the photosensitive-layer-forming composition is applied on the conductive support means an aspect in which the photosensitive-layer-forming composition is applied on the surface of the conductive support to provide a photosensitive layer (directly provided), and an aspect in which the photosensitive-layer-forming composition is applied on an upper side of the surface of the conductive support through another layer to provide a photosensitive layer. The aspect of having the photosensitive layer through another layer above the surface of the conductive support is as

described above.

In the method for manufacturing a photoelectric conversion element of the embodiment of the present invention, applying the photosensitive-layer-forming composition means bringing the photosensitive-layer-forming composition into contact with the surface of the layer on which the photosensitive-layer-forming composition is provided. A method of bringing it in contact is not particularly limited, and well-known methods can be particularly used without any limitation. Specific examples thereof include a method of applying a photosensitive-layer-forming composition to the surface, a method of immersing a surface in the photosensitive-layer-forming composition, and the like.

Hereinafter, the method for manufacturing the photoelectric conversion element and the solar cell of the embodiment of the present invention will be described in brief.

In the photoelectric conversion element of the embodiment of the present invention, first, at least one of the blocking layer 14, the porous layer 12, the electron transport layer 15, or the hole transport layer 16 is formed on a surface of the conductive support 11 according to the purpose.

For example, the blocking layer 14 can be formed by a method in which a dispersion, which contains the insulating substance or a precursor compound thereof, and the like, is applied to the surface of the conductive support 11, and the dispersion is baked; a spray pyrolysis method; and the like.

A material that forms the porous layer 12 is preferably used as fine particles, and more preferably a dispersion that contains the fine particles.

A method of forming the porous layer 12 is not particularly limited, and examples thereof include a wet-type method, a dry-type method, and other methods (for example, a method described in Chemical Review, Vol. 110, p. 6595 (published on 2010)). In these methods, it is preferable that the dispersion (paste) is applied to the surface of the conductive support 11 or the surface of the blocking layer 14 and then the dispersion is baked at a temperature 100°C to 800°C for ten minutes to ten hours, for example, in the air. According to this, it is possible to bring the fine particles into close contact with each other.

In a case where baking is performed a plurality of times, a temperature in baking except final baking (a baking temperature except for a final baking temperature) is preferably set to be lower than the temperature in the final baking (the final baking temperature). For example, in a case where titanium oxide paste is used, the baking temperature except for the final baking temperature can be set in a range of 50°C to 300°C. In addition, the final baking temperature can be set in a range of 100°C to 600°C to be higher than the baking temperature except for the final baking temperature. In a case where a glass support is used as the support 11a, the baking temperature is preferably 60°C to 500°C.

The amount of a porous material applied to form the porous layer 12 is appropriately set in correspondence with the film thickness of the porous layer 12, the number of times of coating, and the like, and there is no particular limitation thereto. For example, the amount of the porous material applied per 1 $m^2$ of a surface area of the conductive support 11 is preferably 0.5 to 500 g, and more preferably 5 to 100 g.

In a case where the electron transport layer 15 or the hole transport layer 16 is provided, the layer can be formed in the same manner as in the hole transport layer 3 or the electron transport layer 4 to be described below.

Subsequently, the photosensitive layer 13 is provided.

In the formation of the photosensitive layer 13, a perovskite precursor compound capable of synthesizing the perovskite compound, and the compound A are used.

The perovskite precursor compound may be any compound that can synthesize the perovskite compound, and examples thereof include the compound AX represented by Formula (A-3) and the compound $MX_2$ represented by Formula (A-2). Each of these compounds may be used alone, may be used as multiple compounds, or may be used as a composition (including a form of solution, suspension, paste, and the like). These compounds can also be used in the form of ions to be formed. For example, instead of the compound AX, as the cation A, an organic cation $R^1\text{-}N(R^{1a})_3^+$ represented by Formula (A-1) or a cation of an element of Group 1 in the periodic table can be used, and furthermore, an anion X can also be used.

The compound A is as described above.

In the present invention, it is preferable to use the photosensitive-layer-forming composition containing the above perovskite precursor compound and the compound A (also referred to as the photosensitive-layer-forming composition of the embodiment of the present invention). As the perovskite precursor compound, it is more preferable to use the photosensitive-layer-forming composition containing a compound represented by Formula (A-2) and a compound represented by Formula (A-3).

Formula (A-0) (G)p-L

Formula (A-2) $MX_2$

Formula (A-3) AX

In the above formulas, G, p, L, M, X, and A are as described above.

In the photosensitive-layer-forming composition, a molar ratio of the compound represented by Formula (A-0), $MX_2$ represented by Formula (A-2), and the compound AX represented by Formula (A-3) is appropriately set according to the purpose.

In the photosensitive-layer-forming composition, a molar ratio between a content $[M^{CCA}]$ of the compound A and a content $[M^{CMC}]$ of the compound $MX_2$ represented by Formula (A-2) is not particularly limited, but the molar ratio is preferably within the following range in terms of temperature change resistance.

$[M^{CCA}]:[M^{CMC}]$ = 4:1 to 1:10000

The above molar ratio is more preferably within the following range.

$[M^{CCA}]:[M^{CMC}]$ = 1:10 to 1:1000

The above molar ratio is even more preferably within the following range.

$[M^{CCA}]:[M^{CMC}]$ = 1:50 to 1:800

In the photosensitive-layer-forming composition, a molar ratio of $MX_2$ represented by Formula (A-2), and the compound AX represented by Formula (A-3) is appropriately adjusted according to the purpose. A molar ratio of AX to $MX_2$ (AX: $MX_2$) is not particularly limited, but is preferably 1:1 to 10:1.

In the photosensitive-layer-forming composition of the embodiment of the present invention, in a case where an organic cation represented by Formula (A-1) and a cation of an element of Group 1 in the periodic table, and an anion X are used instead of the compound AX represented by Formula (A-3), a molar ratio of the content of the cation A and the anion X is set to a molar ratio capable of forming the compound AX represented by Formula (A-3). A molar ratio of organic cation to anion X is generally 1:1, but can be set to 0.1 to 10:10 to 0.1.

The photosensitive-layer-forming composition of the embodiment of the present invention can be prepared by mixing the compound $MX_2$, the compound AX, and the compound A at a predetermined molar ratio and then heating as desired. The photosensitive-layer-forming composition of the embodiment of the present invention is typically a solution (a light absorbing agent solution), but may be a suspension. Heating conditions are not particularly limited. For example, a heating temperature is preferably from 30°C to 200°C, and more preferably from 70°C to 150°C. A heating time is preferably from 0.5 to 100 hours, and more preferably from 1 to 3 hours. As a solvent or a dispersion medium, the following solvent or dispersion medium can be used.

On a photosensitive layer, by using an AX composition containing the compound AX (hereinafter, this composition will be also referred to as an "organic ammonium salt composition"), and an $MX_2$ composition (a metal salt composition) containing the compound $MX_2$, the photosensitive layer 13 can also be formed. In this case, even in a case where the compound A is contained in at least one of the AX composition and the $MX_2$ composition, the third composition (also referred to as the compound A composition) may be contained in addition to the organic ammonium salt composition and the $MX_2$ composition. The organic ammonium salt composition, metal salt composition, and compound A composition are all preferably in the form of a solution, suspension, paste, or the like.

The above-described composition may contain at least one kind of each compound, or may contain two or more kinds thereof.

All of the compositions may contain other components in addition to the above-described compounds.

In a case where these compositions are in a form of powder, granule, or the like, the compositions can be used by dissolving the compositions in a solvent to prepare a solution with an appropriate concentration, and then, as necessary, performing filtering, purifying, and the like. In addition, in a case where the compositions are solutions, the compositions can be used as they are after the compositions are subjected to concentration, dilution, filtration, purification, and the like.

All of the above compositions can be suitably used for forming the photosensitive layer in the manufacture of the photoelectric conversion element of the embodiment of the present invention.

A concentration of solid contents of each of the above compositions is not particularly limited. For example, the concentration of solid contents of the photosensitive-layer-forming composition is preferably from 0.05% to 99% by mass, and more preferably from 0.1% to 55% by mass. A concentration of solid contents of the organic ammonium salt composition is preferably from 0.05% to 90% by mass, and more preferably from 0.1% to 55% by mass. The concentration of solid contents of the metal salt composition is preferably from 0.05% to 95% by mass, and more preferably from 0.1% to 80% by mass.

Examples of a method of providing the photosensitive layer 13 include a wet-type method and a dry-type method, and there is no particular limitation thereto. In the present invention, a wet-type method is preferable, and for example, a method in which the photosensitive-layer-forming composition is brought into contact with the surface of the layer forming the photosensitive layer 13 on the surface thereof (in the photoelectric conversion element 10, any layer of the porous layer 12, the blocking layer 14, the electron transport layer 15, or the hole transport layer 16) is preferable.

Specifically, as the method in which the photosensitive-layer-forming composition is brought into contact with the above surface, applying the photosensitive-layer-forming composition on the surface or immersing the composition is preferable. A contacting temperature is preferably 5°C to 100°C. An immersion time is preferably 5 seconds to 24 hours, more preferably 20 seconds to 1 hour. In a case of drying the photosensitive-layer-forming composition that is

applied, with regard to the drying, drying with heat is preferable, and drying is performed by heating the applied light absorbing agent solution typically at 20°C to 300°C, and preferably at 50°C to 170°C.

In addition, the photosensitive layer can also be formed in conformity to a method of synthesizing the perovskite compound.

Examples of a method of providing the photosensitive layer 13 include a method in which the ammonium salt composition and the metal salt composition are applied separately (including an immersion method) and dried if necessary. In this method, as described above, the compound A is contained in an ammonium salt composition or a metal salt composition, or a composition containing the compound A is used. In the present invention, any solution may be applied first, but preferably the metal salt composition is applied first. In this method, a molar ratio of the compound AX to the compound $MX_2$, the molar ratio of a content [$M^{CCA}$] of the compound A to a content [$M^{CMC}$] of the compound $MX_2$, coating conditions, and drying conditions are the same as in the above method. In this method, AX or $MX_2$ can be vapor-deposited instead of applying the ammonium salt composition and the metal salt composition.

Still another example of the method includes a dry-type method such as a vacuum deposition by using a mixture from which a solvent of the photosensitive-layer-forming composition is removed. For example, a method of simultaneously or sequentially vapor-depositing the compound AX and the compound $MX_2$ may be exemplified.

According to the methods and the like, the perovskite compound is formed on the surface of the porous layer 12, the blocking layer 14, the electron transport layer 15, or the hole transport layer 16 as the photosensitive layer.

In the manufacturing method of the embodiment of the present invention, a layer containing the compound A can be provided on the photosensitive layer 13 thus obtained.

To form a layer containing the compound A, a compound A composition containing the compound A is prepared. The compound A is as described above, and one or more compounds can be used. A content of the compound A in the composition is not particularly limited, and is preferably 100 mmol/L or less, and more preferably 0.001 to 10 mmol/L, for example. The compound A composition contains a solvent. A solvent is not particularly limited, and examples thereof include a solvent or dispersant to be described later. Examples of a method for forming the layer containing the compound A include a method in which the compound A composition and the photosensitive layer 13 are brought into contact with each other. A method of bringing them into contact with each other is the same as the method of providing the photosensitive layer 13, and a preferable method is also the same. It is preferable to apply or dip the compound A composition to the photosensitive layer 13. A contacting temperature is not particularly limited, and is preferably 0°C to 100°C. An immersion time is not particularly limited, and is preferably 1 second to 24 hours. In a case of drying the compound A composition that is applied, with regard to the drying, drying with heat is preferable, and drying is performed by heating the applied light absorbing agent solution typically at 30°C to 200°C, and preferably at 40°C to 110°C.

In this manner, the layer containing the compound A is formed.

The hole transport layer 3 or the electron transport layer 4 is preferably formed on the photosensitive layer 13 or the layer containing the compound A provided as described above.

The hole transport layer 3 can be formed through application and drying of a hole transporting material solution that contains a hole transporting material. In the hole transporting material solution, a concentration of the hole transporting material is preferably 0.1 to 1.0 M (mol/L) when considering that application properties are excellent, and in a case of providing the porous layer 12, the hole transporting material solution easily intrudes into pores of the porous layer 12.

The electron transport layer 4 can be formed through application and drying of an electron transporting material solution that contains an electron transporting material.

After the hole transport layer 3 or the electron transport layer 4 is formed, the second electrode 2 is formed, thereby manufacturing the photoelectric conversion element and the solar cell.

The film thicknesses of the respective layers can be adjusted by appropriately changing the concentrations of respective dispersion liquids or compositions (solutions) and the number of times of application. For example, in a case where the photosensitive layers 13B and 13C having a large film thickness are provided, the photosensitive-layer-forming composition, or the ammonium salt composition or the metal salt composition may be applied plurality of times and dried.

The respective dispersion liquids and compositions described above may respectively contain additives such as a dispersion auxiliary agent and a surfactant as necessary.

Examples of the solvent or dispersion medium that is used in the method for manufacturing the photoelectric conversion element include a solvent described in JP2001-291534A, but the solvent or dispersion medium is not particularly limited thereto. In the present invention, an organic solvent is preferable, and an alcohol solvent, an amide solvent, a nitrile solvent, a hydrocarbon solvent, a lactone solvent, a halogen solvent, and a mixed solvent of two or more kinds thereof are preferable. As the mixed solvent, a mixed solvent of the alcohol solvent and a solvent selected from the amide solvent, the nitrile solvent, and the hydrocarbon solvent is preferable. Specifically, methanol, ethanol, isopropanol, γ-butyrolactone, chlorobenzene, acetonitrile, N,N'-dimethylformamide (DMF), dimethylacetamide, and a mixed solvent thereof are preferable.

A method of applying the compositions or dispersants which form the respective layers is not particularly limited, and it is possible to use a known application method such as spin coating, extrusion die coating, blade coating, bar

coating, screen printing, stencil printing, roll coating, curtain coating, spray coating, dip coating, an inkjet printing method, and an immersion method. Among these, a spin coating method, a screen printing method, and the like are preferable.

The photoelectric conversion element of the embodiment of the present invention may be subjected to an efficiency stabilizing treatment such as annealing, light soaking, and being left as is in an oxygen atmosphere as necessary.

The photoelectric conversion element prepared as described above can be used as a solar cell after connecting the external circuit 6 to the first electrode 1 and the second electrode 2.

Hereinafter, the present invention will be described in more detail based on examples, but the present invention is not limited thereto.

Examples

Example 1

The photoelectric conversion element 10A illustrated in Fig. 1 was manufactured in the following procedure. In a case where the film thickness of the photosensitive layer 13 is large, this case corresponds to the photoelectric conversion element 10B illustrated in Fig. 2.

[Manufacturing of photoelectric conversion element (sample No. 101)]

<Production of conductive support 11>

A fluorine-doped $SnO_2$ conductive film (transparent electrode 11b, film thickness: 300 nm) was formed on a glass substrate (support 11a, thickness: 2 mm) to prepare the conductive support 11.

<Preparation of solution for blocking layer>

15% by mass isopropanol solution (manufactured by Sigma-Aldrich Co. LLC) of titanium diisopropoxide bis(acetylacetonate) was diluted with 1-butanol, thereby preparing 0.02 M solution for a blocking layer.

<Formation of Blocking Layer 14>

The blocking layer 14 (film thickness: 50 nm) formed from titanium oxide was formed on the $SnO_2$ conductive film of the conductive support 11 by using the prepared 0.02 M solution for the blocking layer at 450°C in accordance with a spray pyrolysis method.

<Preparation of titanium oxide paste>

Ethyl cellulose, lauric acid, and terpineol were added to an ethanol dispersion liquid of titanium oxide (anatase, average particle size: 20 nm), thereby preparing titanium oxide paste.

<Formation of porous layer 12>

The prepared titanium oxide paste was applied onto the blocking layer 14 with a screen printing method, and was baked in the air at 500°C for 3 hours. Then, a baked body of the titanium oxide, which was obtained, was immersed in 40 mM TiCl4 aqueous solution, and was heated at 60°C for 1 hour, and heating was continuously performed at 500°C for 30 minutes, thereby forming the porous layer 12 (film thickness: 250 nm) formed from $TiO_2$.

<Preparation of light absorbing agent solution A>

A methanol solution (27.86 mL) of 40% by mass of methyl amine, and an aqueous solution (30 mL) of 57% by mass of hydrogen iodide (hydriodic acid) were stirred in a flask at 0°C for 2 hours, and were concentrated, and therefore coarse $CH_3NH_3I$ was obtained. The coarse $CH_3NH_3I$ obtained was dissolved in ethanol and was recrystallized with diethylether. A precipitated crystal was filtered and collected, and was dried under reduced pressure at 60°C for 5 hours, and therefore purified $CH_3NH_3I$ was obtained.

Next, the purified $CH_3NH_3I$, $PbI_2$, and the compound A1 were mixed at a mixing molar ratio as follows by stirring in DMF at 60°C for 12 hours, and then filtered with a polytetrafluoroethylene (PTFE) syringe filter, and thereby 40% by mass of a light absorbing agent solution A (the photosensitive-layer-forming composition of the embodiment of the

present invention) was prepared.
Purified $CH_3NH_3I$ ($CH_3NH_3^+$):$PbI_2$ = 3:1
Compound A1: $PbI_2$ ([$M^{CCA}$]:[$M^{CMC}$])= 3:1
Purified $CH_3NH_3I$ ($CH_3NH_3^+$):$PbI_2$ ([$M^{CCA}$]):compound A1 ([$M^{CMC}$]) = 3:1:3

A molar ratio of the compound A1 and $PbI_2$ ([$M^{CCA}$]:[$M^{CMC}$]) in the light absorbing agent solution is shown in Table 2.

<Formation of photosensitive layer 13A>

The prepared light absorbing agent solution A was applied (an application temperature: 60°C) onto the porous layer 12 formed on the conductive support 11 with a spin coating method (for 60 seconds at 2000 rpm), and the applied light absorbing agent solution A was dried by using a hot plate at 100°C for 60 minutes, thereby forming the photosensitive layer 13A (film thickness: 300 nm (including the film thickness of 250 nm of the porous layer 12)) including a perovskite compound of $CH_3NH_3PbI_3$ and the compound A1.

In this manner, the first electrode 1A was prepared.

<Preparation of hole transporting material solution>

Spiro-MeOTAD (180 mg) as the hole transporting material was dissolved in chlorobenzene (1 mL). An acetonitrile solution (37.5 μL) obtained by dissolving lithium-bis (trifluoromethanesulfonyl) imide (170 mg) in acetonitrile (1 mL) and t-butyl pyridine (TBP, 17.5 μL) were additionally mixed to the chlorobenzene solution, thereby preparing a hole transporting material solution.

<Formation of hole transport layer 3>

Next, the hole transporting material solution was applied on the photosensitive layer 13 of the first electrode 1 by a spin coating method, and the applied hole transporting material solution was dried, and therefore a hole transport layer 3A (having a film thickness of 100 nm) was formed.

<Production of second electrode 2>

Gold was vapor-deposited on the hole transport layer 3A with a vapor deposition method to prepare the second electrode 2 (film thickness: 100 nm).

In this manner, the photoelectric conversion element 10A (Sample No. 101) was manufactured.

Each film thickness was determined by observation with scanning electron microscope (SEM).

[Manufacturing of Photoelectric Conversion Elements (Sample Nos. 102 to 120, 123, and 124)]

Photoelectric conversion elements 10A of the sample Nos. 102 to 120, 123, and 124 were manufactured in the same manner as in the manufacture of the photoelectric conversion element 10A of the sample No. 101, except that the compound A to be used, or a molar ratio [$M^{CCA}$]:[$M^{CMC}$] was changed as shown in Table 2, in the above-described manufacture of the photoelectric conversion element of the sample No. 101.

In Table 2, "-" in the "Surface treatment" column means that the surface treatment of the photosensitive layer 13A is not performed.

[Manufacturing of photoelectric conversion elements (sample Nos. 121 and 122)]

Photoelectric conversion elements 10A of the sample Nos. 121 and 122 were manufactured in the same manner as in the manufacture of the photoelectric conversion element 10A of the sample No. 101, except that a molar ratio [$M^{CCA}$]:[$M^{CMC}$] was changed as shown in Table 2, and surface treatment of the photosensitive layer 13A was performed as follows, in the above-described manufacture of the photoelectric conversion element of the sample No. 101.

<Surface treatment of photosensitive layer 13A>

A 5 mM chlorobenzene solution of the compound A1 (the compound A composition) was applied to the surface of the photosensitive layer 13A by a spin coating method and then dried at 100°C for 20 minutes to surface-treat the photosensitive layer 13A (a thin film layer containing the compound A was formed).

[Manufacturing of photoelectric conversion elements (sample Nos. c101 to c104)]

Photoelectric conversion elements 10A of the sample Nos. c101 to c104 were manufactured in the same manner as in the manufacture of the photoelectric conversion element 10A of the sample No. 101, except that, as shown in Table 2, using compounds shown in Table 2 instead of the compound A, a molar ratio of this compound to a cation content [$M^{CMC}$] of the metal atom was changed to values shown in the column "[$M^{CCA}$]:[$M^{CMC}$]" in Table 2, or the compound A was not used, in the above-described manufacture of the photoelectric conversion element 10A of the sample No. 101.

In Table 2, for convenience, the compound used in place of the compound A is shown in the "compound A" column, and the molar ratio of the compound to the cation content [$M^{CMC}$] of the metal atom is shown in the column of "[$M^{CCA}$]:[$M^{CMC}$]". In Table 2, "-" in the "compound A" column means that the compound A is not used, and "-" in the "[$M^{CCA}$]:[$M^{CMC}$]" column indicates that calculation is not possible (the same applies to Table 3 to 6).

[Manufacturing of photoelectric conversion elements (sample No. c105)]

A photoelectric conversion element 10A of the sample No. c105 was manufactured in the same manner as in the manufacture of the photoelectric conversion element 10A of the sample No. 104, except that surface treatment of the photosensitive layer 13A was performed in the same manner as in the manufacture of the photoelectric conversion element of the sample No. 121, in the above-described manufacture of the photoelectric conversion element of the sample No. 104.

Compounds S-1 to S-3 used in place of the compound A in the manufacture of the sample Nos. c101 to c103 are shown below.

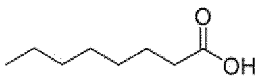

S-1

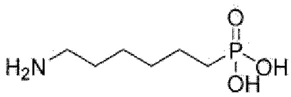

S-2

$H_3PO_4$

S-3

<Measurement of content in light absorbing agent>

The manufactured photoelectric conversion element was disassembled, and the content of each component in the light absorbing agent (photosensitive layer) was measured as follows. From the obtained content, when a molar ratio ([$M^{PCA}$]:[$M^{PMC}$]) of the content [$M^{PCA}$] of the compound A and the metal cation content [$M^{PMC}$] in the light absorbing agent was calculated, it was almost coincided with the molar ratio ([$M^{CCA}$]:[$M^{CMC}$]) value shown in Table 2.

-Decomposition of photoelectric conversion element and quantitative determination of each component-

For each manufactured photoelectric conversion element, the second electrode was made to adhere to an adhesive, and then peeled off, and was also physically removed as needed to be removed from the photoelectric conversion element. Thereafter, the surface from which the second electrode was peeled off was lightly rubbed with a cotton swab soaked in chlorobenzene, or the surface from which the second electrode was peeled off was scraped with a glass plate to expose the surface of the photosensitive layer. The content of the exposed photosensitive layer was calculated by quantifying Pb atoms, P atoms, S atoms, and O atoms by X-ray photoelectron spectroscopy. For photosensitive layers which were difficult to detect by X-ray electron spectroscopy, the photosensitive layer was eluted with an organic solvent, and this was quantified by nuclear magnetic resonance spectrum (NMR), high-performance liquid chromatography (HPLC), gas chromatography (GC) or wave inductively coupled plasma emission spectroscopy (ICP), or a combination thereof.

[Evaluation of photoelectric conversion element]

<Evaluation of temperature change resistance>

Regarding the photoelectric conversion elements of each sample No., the cell characteristic test was performed to evaluate temperature change resistance. The results are shown in Table 2.

Specifically, as described above, six samples of the photoelectric conversion element of sample No. 6 were manufactured. A cell characteristic test was performed on the six samples of each of the manufactured photoelectric conversion elements so as to obtain a photoelectric conversion efficiency. Measurement results were taken as an initial photoelectric conversion efficiency $\eta^I$.

The cell characteristic test was performed by irradiating each photoelectric conversion element with pseudo-solar light of 1000 W/$m^2$ from a xenon lamp through an AM1.5G filter by using a solar simulator "PEC-L15" (manufactured by Peccell Technologies, Inc.). The photoelectric conversion efficiency was obtained by measuring the current-voltage characteristics of each photoelectric conversion element irradiated with pseudo-solar light using a source meter "Keithley 2401" (manufactured by TEKTRONIX, INC.).

All initial photoelectric conversion efficiencies ηI of the photoelectric conversion elements of the sample Nos. 101 to 124 were sufficiently functioned as solar cells.

Next, these samples were then heated from room temperature to 85°C in 5 minutes and maintained at 85°C for 20 minutes. Thereafter, they were cooled to 10°C in 5 minutes, and maintained at 10°C for 10 minutes. This operation was repeated 20 cycles as one cycle. Thereafter, the cell characteristic test was performed again to obtain a photoelectric conversion efficiency. The measurement results were defined as the photoelectric conversion efficiency $\eta^A$ after a temperature change cycle. A decrease rate in photoelectric conversion efficiency of each sample was calculated according to the following equation.

$$\text{Decrease rate} = 1 - (\text{photoelectric conversion efficiency } \eta^A \text{ after temperature change cycle/initial photoelectric conversion efficiency } \eta^I)$$

For each of the photoelectric conversion elements of each sample No., an average of the decrease rates of the six samples was calculated. The calculated value was taken as the average decrease rate.

Next, a relative average decrease rate of the photoelectric conversion element of the each sample No. was obtained by taking an average decrease rate of the photoelectric conversion element of the sample No. c104 as 1. A relative average decrease rate of the photoelectric conversion element of each sample No. is a value obtained by dividing an average decrease rate of the photoelectric conversion element of the each sample No. by the average decrease rate of the sample No. c104.

It was determined which of the following evaluation standard the relative average decrease rate obtained was included.

In this evaluation, an evaluation "E" or higher is practically required, and an evaluation "D" or higher is preferable. As a relative average decrease rate becomes low, temperature change resistance becomes favorable.

-Evaluation standard-

A: Less than 0.26
B: Less than 0.38, and 0.26 or more
C: Less than 0.50, and 0.38 or more
D: Less than 0.62, and 0.50 or more
E: Less than 0.75, and 0.62 or more
F: Less than 0.88, and 0.75 or more
G: Less than 1.01, and 0.88 or more
H: 1.01 or more

<Evaluation of moisture resistance>

As described above, the initial photoelectric conversion efficiency $\eta^I$ was measured in the same manner as in the above <Evaluation of temperature change resistance> except that seven samples of the photoelectric conversion elements of the sample Nos. 114, 121, 122, c104, and c105 were manufactured.

Next, these samples were stored under conditions of 45°C and a relative humidity of 55% for 24 hours, and then the cell characteristic test was carried out again to obtain the photoelectric conversion efficiency. This measurement result was defined as a photoelectric conversion efficiency $\eta^B$ after being left in a humidity environment. A decrease rate in photoelectric conversion efficiency of each sample was calculated according to the following equation.

$$\text{Decrease rate} = 1 - (\text{photoelectric conversion efficiency } \eta^B \text{ after standing in humidity environment/initial photoelectric conversion efficiency } \eta^I)$$

For each of the photoelectric conversion elements of each sample No., an average of the decrease rates of the seven samples was calculated. The calculated value was taken as the average decrease rate.

Next, a relative average decrease rate of the photoelectric conversion element of the each sample No. was obtained by taking an average decrease rate of the sample No. c104 as 1. A relative average decrease rate of the photoelectric conversion element of each sample No. is a value obtained by dividing an average decrease rate of the photoelectric conversion element of the each sample No. by the average decrease rate of the sample No. c104.

It was determined which of the following evaluation standard the relative average decrease rate obtained was included. The results are shown in Table 2. In Table 2, "-" in the "Moisture resistance" column means that the evaluation of moisture resistance is not performed.

In this evaluation, an evaluation "D" or higher is practically required, and an evaluation "C" or higher is preferable. The lower the relative average decrease rate, the better the moisture resistance is.

-Evaluation standard-

A: Less than 0.65
B: Less than 0.70, and 0.65 or more
C: Less than 0.75, and 0.70 or more
D: Less than 0.80, and 0.75 or more
E: 0.80 or more

[Table 2]

| Sample No. | Perovskite compound | Compound A | Moral ratio $M^{CCA}$]: [$M^{CMC}$] | Surface treatment | Temperature change resistance | Moisture resistance | Note |
|---|---|---|---|---|---|---|---|
| 101 | $CH_3NH_3PbI_3$ | A1 | 3:1 | | C | | Present Invention |
| 102 | $CH_3NH_3PbI_3$ | A5 | 3:1 | | C | | Present Invention |
| 103 | $CH_3NH_3PbI_3$ | A6 | 3:1 | | D | | Present Invention |
| 104 | $CH_3NH_3PbI_3$ | A12 | 3:1 | | D | | Present Invention |
| 105 | $CH_3NH_3PbI_3$ | A53 | 3:1 | | E | | Present Invention |
| 106 | $CH_3NH_3PbI_3$ | A110 | 3:1 | | D | | Present Invention |
| 107 | $CH_3NH_3PbI_3$ | A1 | 5:1 | | D | | Present Invention |
| 108 | $CH_3NH_3PbI_3$ | A1 | 4:1 | | C | | Present Invention |
| 109 | $CH_3NH_3PbI_3$ | A1 | 1:1 | | C | | Present Invention |

(continued)

| Sample No. | Perovskite compound | Compound A | Moral ratio $M^{CCA}$]: [$M^{CMC}$] | Surface treatment | Temperature change resistance | Moisture resistance | Note |
|---|---|---|---|---|---|---|---|
| 110 | $CH_3NH_3PbI_3$ | A1 | 1:8 | | C | | Present Invention |
| 111 | $CH_3NH_3PbI_3$ | A1 | 1:10 | | B | | Present Invention |
| 112 | $CH_3NH_3PbI_3$ | A1 | 1:40 | | B | | Present Invention |
| 113 | $CH_3NH_3PbI_3$ | A1 | 1:50 | | A | - | Present Invention |
| 114 | $CH_3NH_3PbI_3$ | A1 | 1:100 | | A | D | Present Invention |
| 115 | $CH_3NH_3PbI_3$ | A1 | 1:800 | | A | - | Present Invention |
| 116 | $CH_3NH_3PbI_3$ | A1 | 1:900 | | B | - | Present Invention |
| 117 | $CH_3NH_3PbI_3$ | A1 | 1:1000 | | B | - | Present Invention |
| 118 | $CH_3NH_3PbI_3$ | A1 | 1:5000 | | C | - | Present Invention |
| 119 | $CH_3NH_3PbI_3$ | A1 | 1:10000 | | C | - | Present Invention |
| 120 | $CH_3NH_3PbI_3$ | A1 | 1:500000 | - | D | - | Present Invention |
| 121 | $CH_3NH_3PbI_3$ | A1 | 1:100 | A1 | A | A | Present Invention |
| 122 | $CH_3NH_3PbI_3$ | A1 | 1:10 | A1 | B | A | Present Invention |
| 123 | $CH_3NH_3PbI_3$ | A80 | 1:100 | - | A | - | Present Invention |
| 124 | $CH_3NH_3PbI_3$ | A111 | 1:100 | - | A | - | Present Invention |
| c101 | $CH_3NH_3PbI_3$ | S-1 | 1:50 | - | H | - | Comparative Example |
| c102 | $CH_3NH_3PbI_3$ | S-2 | 1:50 | - | G | - | Comparative Example |
| c103 | $CH_3NH_3PbI_3$ | S-3 | 1:50 | - | H | - | Comparative Example |
| c104 | $CH_3NH_3PbI_3$ | - | - | - | Standard | Standard | Comparative Example |
| c105 | $CH_3NH_3PbI_3$ | - | - | A1 | G | A | Comparative Example |

Based on the results in Table 2, the following can be understood.

In the photoelectric conversion elements of the sample Nos. c101 to c104 in which the light absorbing agent (photosensitive layer) does not contain the compound A defined in the present invention, a photoelectric conversion efficiency with respect to temperature change significantly decreased. The same applies to the photoelectric conversion element of the sample No. c105 obtained by surface-treating the photosensitive layer.

On the other hand, in the photoelectric conversion elements of the sample Nos. 101 to 124 in which the light absorbing agent (photosensitive layer) contains the compound A defined in the present invention, an amount of decrease in photoelectric conversion efficiency with respect to temperature change was small, and high temperature change resistance was exhibited.

The temperature change resistance of the photoelectric conversion element increases gradually in a case where a range in which a molar ratio ($[M^{PCA}]$:$[M^{PMC}]$) of the content $[M^{PCA}]$ of the compound A and the content $[M^{PMC}]$ of the cation of the metal atom is within a range of 4:1 to 1:10000, then within a range of 1:10 to 1:1000, in particular within a range of 1:50 to 1:800, in the photosensitive layer. In addition, the compound A having $-P(=O)(OR^a)_2$ can impart higher temperature change resistance to the photoelectric conversion element than the compound A having $-SO_3R^a$. Furthermore, in a case where L in Formula (A-0) is an aliphatic hydrocarbon group or an aromatic hydrocarbon group, the photoelectric conversion element has excellent temperature change resistance.

Comparing the photoelectric conversion elements of the sample Nos. 114, 121, and 122, with c104 and c105, it can be understood that temperature change resistance was improved by incorporating the compound A1 in the light absorbing agent. That is, even in a case where the surface of the photosensitive layer is surface-treated with the compound A1 (even in a case where a layer containing the compound A1 is provided on the photosensitive layer), an excellent improvement effect on temperature change resistance is not exhibited. On the other hand, in a case where the compound A1 is contained in the photosensitive layer, as described above, an excellent improvement effect with respect to temperature change resistance is exhibited. Furthermore, in a case where a layer containing the compound A1 is provided on the photosensitive layer 13A, high humidity resistance can be imparted to the photoelectric conversion element.

In Examples 2 to 5, the photoelectric conversion elements manufactured by changing the perovskite compound used in the photosensitive layer were evaluated for temperature change resistance.

Example 2

[Manufacturing of photoelectric conversion element (sample No. 201)]

A photoelectric conversion element 10A of the sample No. 201 was manufactured in the same manner as in the manufacture of the photoelectric conversion element 10A of the sample No. 113, except that the light absorbing agent solution A was changed to the following light absorbing agent solution B, in the manufacture of the photoelectric conversion element 10A of the sample No. 113 in Example 1.

<Preparation of light absorbing agent solution B>

Cesium iodide, formamidine hydroiodide, $CH_3NH_3Br$, lead iodide, and the compound A shown in Table 3 were mixed in the following mixing molar ratio, and the mixture was dissolved in a mixed solvent of DMF and DMSO (dimethyl sulfoxide) (DMF/DMSO = 4/1 (volume ratio)). The obtained liquid was filtered with a polytetrafluoroethylene (PTFE) syringe filter to prepare a 40% by mass light absorbing agent solution B.
Cs:FA:Purified $CH_3NH_3Br$ ($CH_3NH_3^+$) = 0.10:0.20:0.75
(Cs + FA + purified $CH_3NH_3Br$):$PbI_2$ = 1:1
Compound A:$PbI_2$ ($[M^{CCA}]$:$[M^{CMC}]$) = 1:50
(Cs + FA + purified $CH_3NH_3Br$):$PbI_2$:compound A = 1:1:0.02
Br:I = 0.75:2.40
In the above molar ratio and Table 3, "FA" represents a formamidino group ($-C(=NH)NH_2$) (the same applies hereinafter). A molar ratio of Cs, FA, and $CH_3NH_3$ and a molar ratio of Br and I in the perovskite compound in Table 3 are as described above, and therefore the description is omitted.

[Manufacturing of photoelectric conversion elements (sample Nos. c201 and c202)]

Photoelectric conversion elements of the sample Nos. c201 and c202 were manufactured in the same manner as in the manufacture of the photoelectric conversion elements 10A of the sample Nos. c101 and c104, except that the light absorbing agent solution A was changed to the light absorbing agent solution B, in the manufacture of the photoelectric conversion elements of the sample Nos. c101 and c104 in Example 1.

[Evaluation of photoelectric conversion element]

Regarding each manufactured photoelectric conversion element, temperature change resistance was evaluated in the same manner as in Example 1. The evaluation was performed by calculating a relative value with respect to an average decrease rate of the photoelectric conversion element of the sample No. c202. The results are shown in Table 3.

[Table 3]

| Sample No. | Perovskite compound | Compound A | Moral ratio $[M^{CCA}]$:$[M^{CMC}]$ | Temperature change resistance | Note |
|---|---|---|---|---|---|
| 201 | $CsFA(CH_3NH_3)Pb(BrI)_3$ | A1 | 1:50 | A | Present Invention |
| c201 | $CsFA(CH_3NH_3)Pb(BrI)_3$ | S-1 | 1:50 | H | Comparative Example |
| c202 | $CsFA(CH_3NH_3)Pb(BrI)_3$ | - | - | Standard | Comparative Example |

Example 3

[Manufacturing of photoelectric conversion element (sample No. 301)]

A photoelectric conversion element 10A of the sample No. 301 was manufactured in the same manner as in the manufacture of the photoelectric conversion element 10A of the sample No. 113, except that the light absorbing agent solution A was changed to the following light absorbing agent solution C, in the manufacture of the photoelectric conversion element 10A of the sample No. 113 in Example 1.

<Preparation of light absorbing agent solution C>

The purified $CH_3NH_3I$, $PbI_2$, and $SnI_2$, the compound A shown in Table 4 were mixed at a mixing molar ratio as follows by stirring in DMF at 60°C for 12 hours, and then filtered with a polytetrafluoroethylene (PTFE) syringe filter, and thereby 40% by mass of a light absorbing agent solution C was prepared.
Purified $CH_3NH_3I$ $(CH_3NH_3^+)$:$(PbI_2 + SnI_2)$ = 1:1 (0.90 + 0.10)
Compound A:(Pbb + $SnI_2$) ($[M^{CCA}]$:$[M^{CMC}]$) = 1:50
Purified $CH_3NH_3I$:$PbI_2$:$SnI_2$:compound A= 1:0.90:0.10:0.02

[Manufacturing of photoelectric conversion elements (sample Nos. c301 and c302)]

Photoelectric conversion elements of the sample Nos. c301 and c302 were manufactured in the same manner as in the manufacture of the photoelectric conversion elements 10A of the sample Nos. c101 and c104, except that the light absorbing agent solution A was changed to the light absorbing agent solution C, in the manufacture of the photoelectric conversion elements of the sample Nos. c101 and c104 in Example 1.

[Evaluation of photoelectric conversion element]

Regarding each manufactured photoelectric conversion element, temperature change resistance was evaluated in the same manner as in Example 1. The evaluation was performed by calculating a relative value with respect to an average decrease rate of the photoelectric conversion element of the sample No. c302. The results are shown in Table 4.

[Table 4]

| Sample No. | Perovskite compound | Compound A | Moral ratio $[M^{CCA}]$:$[M^{CMC}]$ | Temperature change resistance | Note |
|---|---|---|---|---|---|
| 301 | $CH_3NH_3Pb_{0.9}Sn_{0.1}I_3$ | A1 | 1:50 | A | Present Invention |
| c301 | $CH_3NH_3Pb_{0.9}Sn_{0.1}I_3$ | S-1 | 1:50 | H | Comparative Example |

(continued)

| Sample No. | Perovskite compound | Compound A | Moral ratio [$M^{CCA}$]:[$M^{CMC}$] | Temperature change resistance | Note |
|---|---|---|---|---|---|
| c302 | $CH_3NH_3Pb_{0.9}Sn_{0.1}I_3$ | - | - | Standard | Comparative Example |

Example 4

[Manufacturing of photoelectric conversion element (sample No. 401)]

A photoelectric conversion element 10A of the sample No. 401 was manufactured in the same manner as in the manufacture of the photoelectric conversion element 10A of the sample No. 113, except that the light absorbing agent solution A was changed to the following light absorbing agent solution D, in the manufacture of the photoelectric conversion element 10A of the sample No. 113 in Example 1.

<Preparation of light absorbing agent solution D>

Formamidine hydroiodide, lead iodide, and the compound A shown in Table 5 were mixed at a mixing molar ratio as follows by stirring in DMF at 60°C for 12 hours, and then filtered with a polytetrafluoroethylene (PTFE) syringe filter, and thereby 40% by mass of a light absorbing agent solution D was prepared.
FA:$PbI_2$ = 1:1
Compound A:$PbI_2$ ([$M^{CCA}$]:[$M^{CMC}$]) = 1:50
FA:$PbI_2$:compound A= 1:1:0.02

[Manufacturing of photoelectric conversion elements (sample Nos. c401 and c402)]

Photoelectric conversion elements of the sample Nos. c401 and c402 were manufactured in the same manner as in the manufacture of the photoelectric conversion elements 10A of the sample Nos. c101 and c104, except that the light absorbing agent solution A was changed to the light absorbing agent solution D, in the manufacture of the photoelectric conversion elements of the sample Nos. c101 and c104 in Example 1.

[Evaluation of photoelectric conversion element]

Regarding each manufactured photoelectric conversion element, temperature change resistance was evaluated in the same manner as in Example 1. The evaluation was performed by calculating a relative value with respect to an average decrease rate of the photoelectric conversion element of the sample No. c402. The results are shown in Table 5.

[Table 5]

| Sample No. | Perovskite compound | Compound A | Moral ratio [$M^{CCA}$]:[$M^{CMC}$] | Temperature change resistance | Note |
|---|---|---|---|---|---|
| 401 | $FAPbI_3$ | A1 | 1:50 | A | Present Invention |
| c401 | $FAPbI_3$ | S-1 | 1:50 | H | Comparative Example |
| c402 | $FAPbI_3$ | - | - | Standard | Comparative Example |

Example 5

[Manufacturing of photoelectric conversion element (sample No. 501)]

A photoelectric conversion element 10A of the sample No. 501 was manufactured in the same manner as in the manufacture of the photoelectric conversion element 10A of the sample No. 113, except that the light absorbing agent solution A was changed to the following light absorbing agent solution E, in the manufacture of the photoelectric

conversion element 10A of the sample No. 113 in Example 1.

<Preparation of light absorbing agent solution E>

The purified $CH_3NH_3I$, purified $BuNH_3I$ synthesized in the same manner as purified $CH_3NH_3I$, $PbI_2$, and $SnI_2$, the compound A shown in Table 6 were mixed at a mixing molar ratio as follows by stirring in DMF at 60°C for 12 hours, and then filtered with a polytetrafluoroethylene (PTFE) syringe filter, and thereby 40% by mass of a light absorbing agent solution E was prepared.
Purified $CH_3NH_3I$ ($CH_3NH_3^+$):purified $BuNH_3I$ ($BuNH_3^+$) = 0.95:0.05
$PbI_2$ + $SnI_2$ = 0.90:0.10
(Purified $CH_3NH_3I$ + purified $BuNH_3I$):($PbI_2$ + $SnI_2$) = 1:1
Compound A:($PbI_2$ + $SnI_2$) ([$M^{CCA}$]:[$M^{CMC}$]) = 1:50
Purified $CH_3NH_3I$:purified $BuNH_3I$:$PbI_2$:$SnI_2$:compound A = 0.95:0.05:0.90:0.10:0.02
In the above molar ratio and Table 6, "Bu" represents butyl. In Table 6, the molar ratio of $CH_3NH_3^+$ to $BuNH_3^+$ is as described above, and therefore the description is omitted.

[Manufacturing of photoelectric conversion elements (sample Nos. c501 and c502)]

Photoelectric conversion elements of the sample Nos. c501 and c502 were manufactured in the same manner as in the manufacture of the photoelectric conversion elements 10A of the sample Nos. c101 and c104, except that the light absorbing agent solution A was changed to the light absorbing agent solution E, in the manufacture of the photoelectric conversion elements of the sample Nos. c101 and c104 in Example 1.

[Evaluation of photoelectric conversion element]

Regarding each manufactured photoelectric conversion element, temperature change resistance was evaluated in the same manner as in Example 1. The evaluation was performed by calculating a relative value with respect to an average decrease rate of the photoelectric conversion element of the sample No. c502. The results are shown in Table 6.

[Table 6]

| Sample No. | Perovskite compound | Compound A | Moral ratio [$M^{CCA}$]:[$M^{CMC}$] | Temperature change resistance | Note |
|---|---|---|---|---|---|
| 501 | $(CH_3NH_3)(BuNH_3)Pb_{0.9}Sn_{0.1}I_3$ | A1 | 1:50 | A | Present Invention |
| c501 | $(CH_3NH_3)(BuNH_3)Pb_{0.9}Sn_{0.1}I_3$ | S-1 | 1:50 | H | Comparative Example |
| c502 | $(CH_3NH_3)(BuNH_3)Pb_{0.9}Sn_{0.1}I_3$ | - | - | Standard | Comparative Example |

Based on the results in Tables 3 to 6, it can be understood that, in the case where the light absorbing agent (photosensitive layer) contains the perovskite compound and the compound specified in the present invention, it shows high temperature change resistance regardless of the type of the perovskite compound.

Explanation of References

1A to 1F: first electrode
11: conductive support
11a: support
11b: transparent electrode
12: porous layer
13A to 13C: photosensitive layer
14: blocking layer
2: second electrode

3A, 3B, 16: hole transport layer
4, 15: electron transport layer
6: external circuit (lead)
10A to 10F: photoelectric conversion element
100A to 100F: system using solar cell
M: electric motor

## Claims

**1.** A photoelectric conversion element, comprising:

a first electrode that includes a photosensitive layer containing a light absorbing agent on a conductive support; and
a second electrode that is opposite to the first electrode,
wherein the light absorbing agent contains a compound having a perovskite-type crystal structure that has a cation of an element of Group 1 in the periodic table or an organic cation, a cation of a metal atom other than elements of Group 1 in the periodic table, and an anion of an anionic atom or atomic group, and contains a compound represented by Formula (A-0),

Formula (A-0) (G)p-L

in the formula, G represents a group or a salt selected from the group consisting of $-SO_3R^a$, $-SO_3^-Ya^+$, $-P(=O)(OR^a)_2$, $-P(=O)(O^-Ya^+)_2$, $-P(=O)R^G(OR^a)$, $-P(=O)R^G(O^-Ya^+)$, $-B(OR^a)_2$, $-OB(OR^a)_2$, and $-B(OR^a)_3^-Ya^+$; $R^a$ represents a hydrogen atom or a substituent; $R^G$ represents a substituent; Ya represents a counter salt; p is an integer of 1 or more; and L represents an aliphatic hydrocarbon group, an aromatic hydrocarbon group, an aromatic heterocyclic group, or an aliphatic heterocyclic group, provided that L does not have an amino group.

**2.** The photoelectric conversion element according to claim 1, wherein, in the photosensitive layer, a molar ratio between a content $[M^{PCA}]$ of the compound represented by Formula (A-0) and a content $[M^{PMC}]$ of the cation of the metal atom is within the following range.
$[M^{PCA}]:[M^{PMC}]$ = 4:1 to 1:10000

**3.** The photoelectric conversion element according to claim 2, wherein the molar ratio is within the following range.
$[M^{PCA}]:[M^{PMC}]$ = 1:10 to 1:1000

**4.** The photoelectric conversion element according to claim 2 or 3, wherein the molar ratio is within the following range.
$[M^{PCA}]:[M^{PMC}]$ = 1:50 to 1:800

**5.** The photoelectric conversion element according to any one of claims 1 to 4, wherein G is $-P(=O)(OR^a)_2$ or $-P(=O)(O^-Ya^+)_2$.

**6.** The photoelectric conversion element according to any one of claims 1 to 5, wherein L is an aliphatic hydrocarbon group or an aromatic hydrocarbon group.

**7.** The photoelectric conversion element according to any one of claims 1 to 6, wherein L has a substituent selected from the following group $L^{SG}$.
<Group $L^{SG}$>
an alkyl group, an alkenyl group, an alkynyl group, an aryl group, an alkoxy group, an aryloxy group, a heteroaryloxy group, an alkylthio group, an arylthio group, a heteroarylthio group, an alkoxycarbonyl group, an aryloxycarbonyl group, a heteroaryloxycarbonyl group, an alkylthiocarbonyl group, an arylthiocarbonyl group, a heteroarylthiocarbonyl group, an alkylcarbonyloxy group, an arylcarbonyloxy group, a heteroarylcarbonyloxy group, an alkylcarbonylthio group, an arylcarbonylthio group, a heteroarylcarbonylthio group, a hydroxy group, a mercapto group, an acyl group, a halogen atom, a cyano group, a silyl group, a heteroaryl group, an aliphatic heterocyclic group, and a carbamoyl group

**8.** A solar cell which is formed of the photoelectric conversion element according to any one of claims 1 to 7.

**9.** A method for manufacturing a photoelectric conversion element which includes a first electrode having a photosensitive layer on a conductive support, and a second electrode that is opposite to the first electrode, the method comprising:
a step of applying, on the conductive support, a photosensitive-layer-forming composition which contains a perovskite precursor compound for forming a compound having a perovskite-type crystal structure that has a cation of an element of Group 1 in the periodic table or an organic cation, a cation of a metal atom other than elements of Group 1 in the periodic table, and an anion of an anionic atom or atomic group, and which contains a compound represented by Formula (A-0),

Formula (A-0) (G)p-L

in the formula, G represents a group or a salt selected from the group consisting of $-SO_3R^a$, $-SO_3^-Ya^+$, $-P(=O)(OR^a)_2$, $-P(=O)(O^-Ya^+)_2$, $-P(=O)R^G(OR^a)$, $-P(=O)R^G(O^-Ya^+)$, $-B(OR^a)_2$, $-OB(OR^a)_2$, and $-B(OR^a)_3^-Ya^+$; $R^a$ represents a hydrogen atom or a substituent; $R^G$ represents a substituent; Ya represents a counter salt; p is an integer of 1 or more; and L represents an aliphatic hydrocarbon group, an aromatic hydrocarbon group, an aromatic heterocyclic group, or an aliphatic heterocyclic group, provided that L does not have an amino group.

**10.** The method for manufacturing a photoelectric conversion element according to claim 9,
wherein the perovskite precursor compound includes a compound represented by Formula (A-2) and a compound represented by Formula (A-3),

Formula (A-2) $MX_2$

Formula (A-3) AX

in Formula (A-2), M represents a metal atom other than elements of Group 1 in the periodic table, and X represents an anionic atom or an atomic group, and
in Formula (A-3), A represents an element of Group 1 in the periodic table or a cationic organic group, and X represents an anionic atom or an atomic group.

**11.** A photosensitive-layer-forming composition comprising:

a compound represented by Formula (A-0);
a compound represented by Formula (A-2); and
a compound represented by Formula (A-3),

Formula (A-0) (G)p-L

Formula (A-2) $MX_2$

Formula (A-3) AX

in Formula (A-0), G represents a group or a salt selected from the group consisting of $-SO_3R^a$, $-SO_3^-Ya^+$, $-P(=O)(OR^a)_2$, $-P(=O)(O^-Ya^+)_2$, $-P(=O)R^G(OR^a)$, $-P(=O)R^G(O^-Ya^+)$, $-B(OR^a)_2$, $-OB(OR^a)_2$, and $-B(OR^a)_3^-Ya^+$; $R^a$ represents a hydrogen atom or a substituent; $R^G$ represents a substituent; Ya represents a counter salt; p is an integer of 1 or more; and L represents an aliphatic hydrocarbon group, an aromatic hydrocarbon group, an aromatic heterocyclic group, or an aliphatic heterocyclic group, provided that L does not have an amino group,
in Formula (A-2), M represents a metal atom other than elements of Group 1 in the periodic table, and X represents an anionic atom or an atomic group, and
in Formula (A-3), A represents an element of Group 1 in the periodic table or a cationic organic group, and X represents an anionic atom or an atomic group.

**12.** The photosensitive-layer-forming composition according to claim 11, wherein a molar ratio between a content $[M^{CCA}]$ of the compound represented by Formula (A-0) and a content $[M^{CMC}]$ of the compound $MX_2$ represented by Formula (A-2) is within the following range.
$[M^{CCA}]:[M^{CMC}]$ = 1:10 to 1:1000

**13.** The photosensitive-layer-forming composition according to claim 11 or 12, further comprising an organic solvent.

FIG. 1

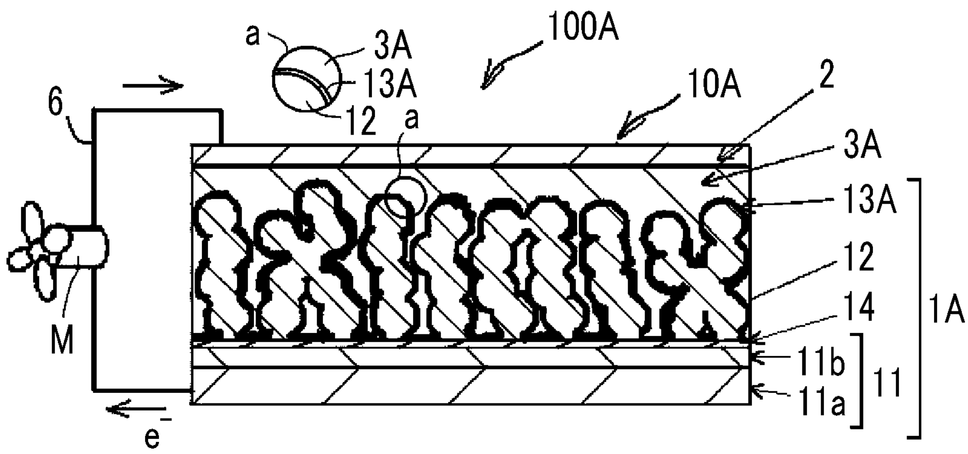


FIG. 2

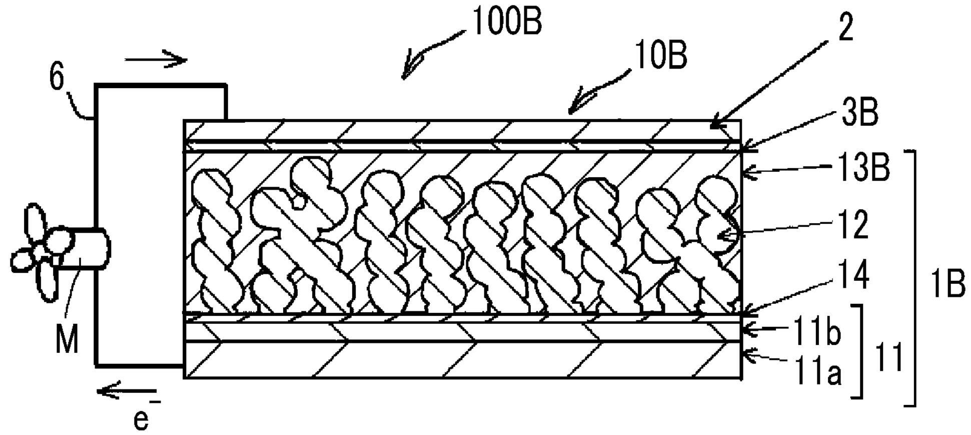


FIG. 3

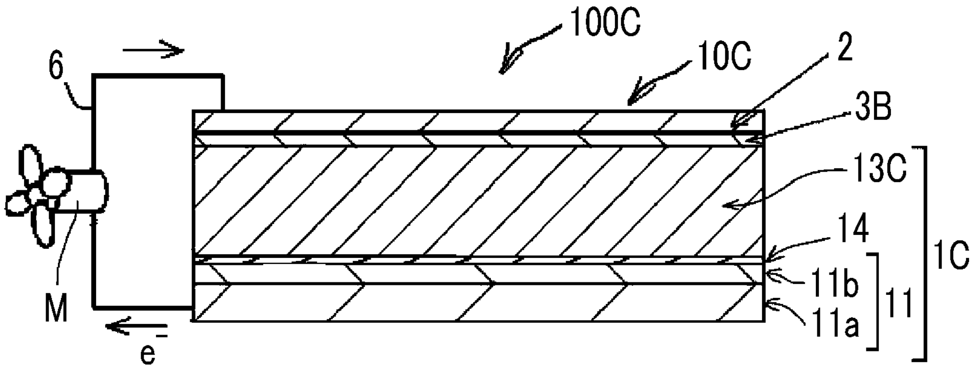

FIG. 4

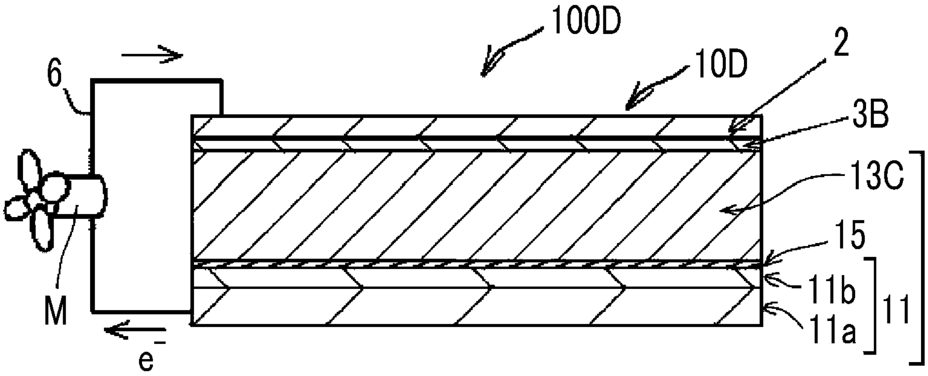


FIG. 5

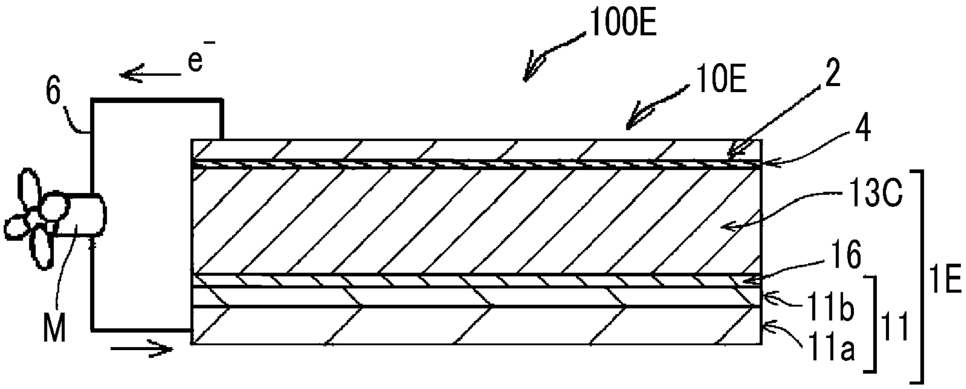


FIG. 6

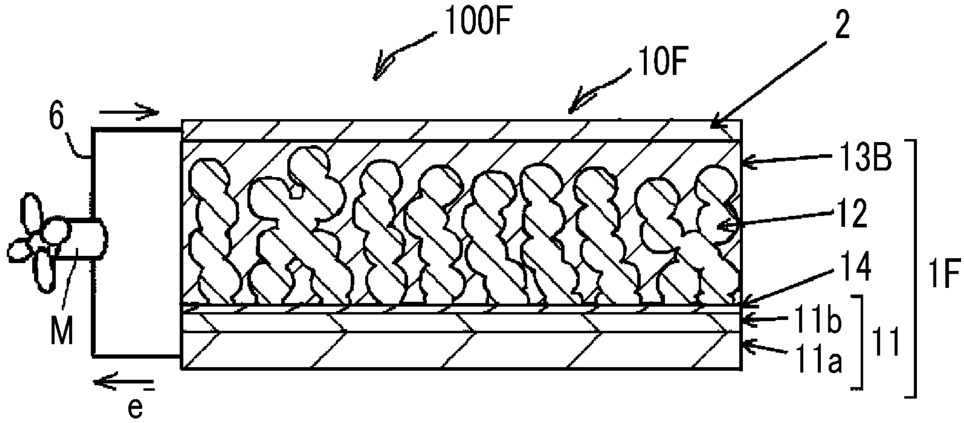

**INTERNATIONAL SEARCH REPORT**

International application No. PCT/JP2018/014503

A. CLASSIFICATION OF SUBJECT MATTER
Int.Cl. H01L51/44(2006.01)i, H01G9/20(2006.01)i

According to International Patent Classification (IPC) or to both national classification and IPC

B. FIELDS SEARCHED

Minimum documentation searched (classification system followed by classification symbols)
Int.Cl. H01L51/42-51/48, H01G9/20

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2015-216359 A (FUJIFILM CORP.) 03 December 2015, paragraphs [0007]-[0011], [0034]-[0040], [0069]-[0077], [0097]-[0105], [0193]-[0208] (Family: none) | 1-8<br>9-13 |
| X<br>Y | JP 2017-28093 A (SEKISUI CHEMICAL CO., LTD.) 02 February 2017, paragraphs [0008], [0028]-[0032], [0058] (Family: none) | 1-8<br>9-13 |
| Y | JP 2016-178274 A (MITSUBISHI CHEMICAL CORP.) 06 October 2016, paragraphs [0012]-[0056], [0068]-[0143] (Family: none) | 9-13 |
| Y | US 2016/0079552 A1 (NATIONAL TAIWAN UNIVERSITY) 17 March 2016, paragraphs [0011]-[0036] (Family: none) | 9-13 |
| A | KOH, Weon-kyu et al., "Phosphonic Acid Stabilized Colloidal $CsPbX_3$ (X=Br, I) Perovskite Nanocrystals and Their Surface Chemistry", ChemistrySelect, 2016, vol. 1, pp. 3479-3482 | 1-13 |
| P, X | JP 2017-112185 A (MITSUBISHI CHEMICAL CORP.) 22 June 2017, paragraphs [0010]-[0055], [0068]-[0106] (Family: none) | 1-13 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 April 2018 (24.04.2018) | 15 May 2018 (15.05.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2016143525 A
- JP 2017028093 A
- JP 2001291534 A
- US 4927721 A
- US 4684537 A
- US 5084365 A
- US 5350644 A
- US 5463057 A
- US 5525440 A
- JP 7249790 A
- JP H7249790 A
- JP 2004220974 A
- JP 2008135197 A
- JP 2005135902 A
- JP 2001160425 A
- JP 2003123859 A
- JP 2002260746 A


### Non-patent literature cited in the description


- *Nature Communications,* 2015, vol. 6, 10030
- *Nature Chemistry,* 2015, vol. 7, 703-711
- *J. Am. Chem. Soc.,* 2009, vol. 131 (17), 6050-6051
- *Science,* 2012, vol. 338, 643
- **AKIHIRO KOJIMA ; KENJIRO TESHIMA ; YASUO SHIRAI ; TSUTOMU MIYASAKA.** Organometal Halide Perovskites as Visible-Light Sensitizers for Photovoltaic Cells. *J. Am. Chem. Soc.,* 2009, vol. 131 (17), 6050-6051
- *Chemical Review,* 2010, vol. 110, 6595